(19) Europäisches Patentamt
European Patent Office
Office européen des brevets

(11) **EP 3 650 993 A1**

(12) **EUROPEAN PATENT APPLICATION**

(43) Date of publication:
**13.05.2020** Bulletin 2020/20

(51) Int Cl.:
**G06F 3/01** (2006.01)    **G06F 3/041** (2006.01)
**H01H 3/00** (2006.01)

(21) Application number: **19208144.6**

(22) Date of filing: **08.11.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.11.2018 US 201862758435 P**
**25.09.2019 US 201916581992**

(71) Applicant: **Immersion Corporation**
**San Jose CA 95134 (US)**

(72) Inventors:
• **Karimi Eskandary, Peyman**
  **Montreal, Quebec H2X 2N4 (CA)**
• **Cruz Hernandez, Juan Manuel**
  **Montreal, Quebec H3Z 1T1 (CA)**

(74) Representative: **Latscha Schöllhorn Partner AG**
**Grellingerstrasse 60**
**4052 Basel (CH)**

(54) **DEVICES AND METHODS FOR CONTROLLING A HAPTIC ACTUATOR**

(57)    A haptic-enabled device having a haptic actuator, a movement sensor, and a control circuit is presented. The control circuit determines a drive signal for the haptic actuator based on desired movement for a haptic effect and based on a model that describes transient behavior of the haptic actuator. The control circuit further measures movement output by the haptic actuator based on the drive signal being applied to the haptic actuator. The control circuit determines a movement error that indicates a difference between the measured movement and the desired movement, and adjusts the drive signal based on the movement error to generate an adjusted drive signal. The adjusted drive signal is applied to the haptic actuator to generate the haptic effect. Numerous other aspects are provided.

FIG. 5C

**Description**

FIELD OF THE INVENTION

The present invention is directed to a device and method for controlling a haptic actuator, and has application in mobile computing, virtual reality or augmented reality devices, gaming, wearables, or in any other user interface device.

BACKGROUND

As electronic user interface systems become more prevalent, the quality of the interfaces through which humans interact with these systems is becoming increasingly important. Haptic feedback, or more generally haptic effects, can improve the quality of the interfaces by providing cues to users, providing alerts of specific events, or providing realistic feedback to create greater sensory immersion within a virtual environment. Examples of haptic effects include kinesthetic haptic effects (such as active and resistive force feedback), vibrotactile haptic effects, and electrostatic friction haptic effects. The haptic effects may be generated by generating a drive signal and applying the drive signal to a haptic actuator.

SUMMARY

One aspect of the embodiments herein relates to a haptic-enabled device that is configured to use a hybrid form of control to generate a haptic effect. The haptic-enabled device comprises a haptic actuator, a movement sensor, and a control circuit. The control circuit is configured to determine a drive signal for the haptic actuator based on desired movement for the haptic effect and based on a model that describes transient behavior of the haptic actuator, wherein the desired movement is defined by information stored on the haptic-enabled device. The control circuit is also configured to apply the drive signal to the haptic actuator. The control circuit is further configured to measure, via the movement sensor, movement output (e.g., being output) by the haptic actuator based on (e.g., as the) drive signal is being applied to the haptic actuator, so as to determine a measured movement of the haptic actuator. The control circuit is also configured to determine a movement error that indicates a difference between the measured movement output (e.g., being output) by the haptic actuator and the desired movement. Further, the control circuit is configured to adjust the drive signal based on the movement error, so as to generate an adjusted drive signal (e.g., that is based on both (i) the model of the haptic actuator and (ii) an adjustment that compensates against the movement error). Additionally, the control circuit is configured to apply the adjusted drive signal to the haptic actuator to control the haptic actuator to generate the haptic effect.

One aspect of the embodiments herein relates to a haptic-enabled device, comprising a haptic actuator, a movement sensor, and a control circuit configured to receive a parameter value of a haptic parameter that describes desired movement for a haptic effect to be generated by the haptic actuator. The control circuit is further configured to generate a driving portion of a drive signal based on the parameter value. The control circuit is further configured to apply the driving portion of the drive signal to the haptic actuator. The control circuit is also configured to measure, via the movement sensor, movement output (e.g., being output) by the haptic actuator so as to determine a measured movement of the haptic actuator. Additionally, the control circuit is configured to generate (e.g., after the driving portion is generated) a braking portion of the drive signal based on the measured movement, for example, by using closed-loop control to cause the measured movement to move (e.g., converge) toward a defined characteristic. Numerous other aspects are provided.

Features, objects, and advantages of embodiments hereof will become apparent to those skilled in the art by reading the following detailed description where references will be made to the appended figures.

BRIEF DESCRIPTION OF THE DRAWINGS

The foregoing and other features and advantages of the invention will be apparent from the following description of embodiments hereof as illustrated in the accompanying drawings. The accompanying drawings, which are incorporated herein and form a part of the specification, further serve to explain the principles of the invention and to enable a person skilled in the pertinent art to make and use the invention. The drawings are not to scale.

     FIG. 1 provides a block diagram illustrating a haptic-enabled device for controlling a haptic actuator to generate a haptic effect, according to an aspect hereof.

     FIG. 2A provides a block diagram of a non-transitory computer readable medium having a model of a haptic actuator and having information that defines desired movement for a haptic effect, according to an aspect hereof.

     FIG. 2B provides a block diagram of a non-transitory computer readable medium having a model of a haptic actuator and desired parameter values for movement to be output by a haptic actuator for a haptic effect, according to an aspect hereof.

     FIGS. 3A and 3B illustrate placement of a haptic actuator within a haptic-enabled device, according to an aspect hereof.

FIGS. 4A-4E illustrate placement of a haptic actuator within a haptic-enabled device, according to an aspect hereof.

FIG. 5A illustrates use of only open-loop control to generate a haptic effect.

FIG. 5B illustrates using a hybrid form of control that combines open-loop control and closed-loop control for generating a haptic effect, according to an aspect hereof.

FIG. 5C provides a flow diagram that illustrates an example method for controlling a haptic actuator to generate a haptic effect, according to an aspect hereof.

FIGS. 6A and 6B illustrates a comparison of reference acceleration for a haptic effect and measured acceleration that is output by a haptic actuator, according to an aspect hereof.

FIGS. 7A and 7B illustrates a comparison of reference acceleration for a haptic effect and measured acceleration that is output by a haptic actuator, according to an aspect hereof.

FIGS. 8A-8D illustrates a comparison of reference acceleration for a haptic effect and measured acceleration that is output by a haptic actuator, according to an aspect hereof.

FIG. 8E illustrates a relationship between maximum peak-to-peak acceleration that a haptic actuator is rated to achieve at different frequencies, according to an aspect hereof.

FIG. 9A illustrates a hybrid form of control that combines open-loop control to generate a driving portion of a drive signal and closed-loop control to generate a braking portion of a drive signal, according to an aspect hereof.

FIG. 9B provides a flow diagram that illustrates an example method for controlling a haptic actuator to generate a haptic effect, according to an aspect hereof.

FIGS. 9C illustrates a drive signal that is generated based on the hybrid form of control illustrated in FIGS. 9A and 9B, according to an aspect hereof.

FIG. 10 illustrates respective accelerations output by a haptic actuator using different control techniques, according to an aspect hereof.

FIG. 11 illustrates respective accelerations generated by different haptic actuators using the hybrid form of control, according to an aspect hereof.

## DETAILED DESCRIPTION

The following detailed description is merely exemplary in nature and is not intended to limit the invention or the application and uses of the invention. Furthermore, there is no intention to be bound by any expressed or implied theory presented in the preceding technical field, background, brief summary or the following detailed description.

Embodiments herein relate to devices and methods for controlling a haptic actuator, such as a linear resonant actuator (LRA) or linear motor, to cause the haptic actuator to output movement (e.g., acceleration) which closely matches or is identical to desired movement (e.g., desired acceleration) for a haptic effect, or to output movement that has a desired parameter value of a haptic parameter (e.g., an acceleration parameter). The devices and methods in these embodiments may control the haptic actuator, for example, with a hybrid controller functionality that combines open-loop control and closed-loop control, as described below in more detail. This hybrid controller functionality may also be referred to as feed forward with closed loop control, or as a hybrid form of control. In some cases, the hybrid form of control may be used to implement a tracking functionality and/or a replication functionality, as described below in more detail.

In an embodiment, the tracking functionality involves controlling the haptic actuator to output movement that closely matches a waveform that describes desired movement for a haptic effect as a function of time. In one example, the desired movement may be desired acceleration for the haptic effect, and the waveform may describe values for the desired acceleration as a function of time. In other words, such a waveform may describe a function $a_{desired}(t)$. In aspects, a hybrid form of control may be used to control the haptic actuator to output acceleration over time (which may be described by a function $a(t)$) in a manner that closely matches the waveform $a_{desired}(t)$ representing the desired acceleration. In the embodiments herein, the desired movement may also be referred to herein as reference movement, and the desired acceleration may also be referred to as reference acceleration.

In an embodiment, the replication functionality involves controlling the haptic actuator to output movement that follows a desired parameter value(s) for a haptic parameter(s). The desired parameter value may be used, in addition to or instead of the waveform described above with respect to the tracking functionality, to control movement output by the haptic actuator. In some cases, the haptic parameter may be an acceleration parameter that describes a characteristic of desired acceleration for a haptic effect. For instance, the desired acceleration may be a time-varying acceleration $a_{desired}(t)$, and the haptic parameter may be a number of peaks (e.g., 3 peaks) in the desired acceleration $a_{desired}(t)$ throughout a duration of the haptic effect, a frequency content for the desired acceleration, and/or a maximum peak-to-peak magnitude of the desired acceleration.

In an embodiment, the replication functionality may further involve controlling the haptic actuator with a driving signal that has a driving portion and a braking portion, and generating the driving portion and the braking portion in different ways. More specifically, the driving portion may be generated in an open-loop manner, while the braking portion may be generated in a closed-loop manner. The open-loop control may generate the driving portion based on a defined function (e.g., a transfer function) that is configured to convert a parameter value of the above haptic parameter to a drive signal, or to a parameter value of the drive signal. For instance, if the driving portion is a square wave, the open-loop control may generate the square wave to have a peak-to-peak acceleration, a number of peaks, a frequency content, and/or some other parameter value specified by the haptic parameter. In this embodiment, the closed-loop control may generate the braking portion to attempt to drive movement of the haptic actuator toward a desired characteristic. For example, the closed-loop control may generate the braking portion to drive acceleration being output by the haptic actuator toward zero.

As stated above, the haptic actuator may be controlled so as to output movement (e.g., acceleration) that closely matches desired movement (e.g., desired acceleration) for a haptic effect, or to output movement having a parameter value that closely matches a desired parameter value of a haptic parameter. In an embodiment, controlling the haptic actuator may be based on a measurement made via a movement sensor, which may measure displacement output by the haptic actuator, speed output by the haptic actuator, acceleration output by the haptic actuator, force output by the haptic actuator, or some other aspect of movement output by the haptic actuator. In some situations, although it may be easier to control the haptic actuator based on measuring displacement or speed output by the haptic actuator, it may still be more advantageous to control the haptic actuator based on measuring acceleration output by the haptic actuator, because of the generally better accuracy, lower cost, and/or high reliability of acceleration sensors (which may also be referred to as accelerometers).

As also stated above, one aspect of the embodiments herein relate to a hybrid form of control that uses open-loop control and closed-loop control. This hybrid form of control may be used to, e.g., control a haptic actuator to output acceleration that tracks a waveform representing desired acceleration. In an embodiment, the open-loop control may rely on a model of the haptic actuator, wherein the model may describe transient behavior of the haptic actuator. For instance, the model may approximate an electrical property (e.g., electrical inductance, electrical resistance) and/or a mechanical property (e.g., mass, moment of inertia, damping) of the haptic actuator. In some instances, the model may include an inverse transfer function that relates movement to drive signal, or that more specifically relates acceleration to drive signal (e.g., a voltage signal or electrical current signal). For example, the inverse transfer function may be configured to convert desired acceleration (e.g., $a_{desired}(t)$), which may be an input to the inverse transfer function, to a drive signal (e.g., $d(t)$), which may be an output of the inverse transfer function. The open-loop control may, e.g., rely on the inverse transfer function in the model of a particular haptic actuator to generate a drive signal based on a desired acceleration to be output by that haptic actuator.

In some cases, reliance on the open-loop control alone may not be sufficient to provide robust control of a haptic actuator, because of limitations in the model. For instance, the haptic actuator may not have been manufactured to an extremely tight tolerance, in order to keep cost low for the haptic actuator. When a batch of haptic actuators are manufactured, only a few of the haptic actuators may have been evaluated to determine a model that nominally applies to all haptic actuators in the batch or to all haptic actuators that are of the same type of haptic actuator as the evaluated haptic actuators. Because of the relaxed manufacturing tolerance, however, a particular haptic actuator in the batch of haptic actuators may deviate from the model, and the haptic actuators may have variations among each other. Thus, the parameter values, the inverse transfer function, or other aspect of the model may provide only an imperfect approximation of the actual behavior (e.g., transient behavior) of a particular haptic actuator in the batch. Moreover, the use open-loop control alone may further be insufficient because a haptic actuator may be a non-minimum phase (NMP) system. The NMP system may exhibit positive zeros or positive poles, which may render the system difficult to control with only open-loop control.

In some cases, reliance on closed-loop control alone may also be insufficient to provide robust control of a haptic actuator, because the closed-loop control may not cause movement of the haptic actuator to converge toward desired movement sufficiently quickly. For example, if a haptic effect is being generated to simulate the click of a virtual button, a total duration of the haptic effect may be fairly short. In such a situation, the haptic actuator may need to output movement that quickly begins to converge toward the desired movement for the haptic effect, well before the haptic effect is about to end. For such a situation, the closed-loop control alone may sometimes fail to cause the movement being output by the haptic actuator to sufficiently quickly match the desired movement for the haptic effect. Accordingly, one aspect of the embodiments herein rely on the hybrid form of control that uses both open-loop control and closed-loop control to generate a haptic effect.

In an embodiment, the hybrid form of control may involve generating a drive signal (e.g. one or more portions thereof) using open-loop control, such as based on a model that describes transient behavior of a haptic actuator, and adjusting the drive signal (e.g., one or more portions thereof) based on closed-loop control as the drive signal is being applied to the haptic actuator. In an embodiment, the hybrid form of control may involve generating a driving portion of a drive signal and a braking portion of the drive signal in different ways. For instance, the hybrid form of control may initially operate in an open-loop manner to generate a driving portion that is a square wave, a sinusoidal wave, or some other driving portion. When the square wave is finished or about to be finished, the hybrid form of control for the haptic actuator may switch from using open-loop control for generating the square wave to using closed-loop control to brake or otherwise stop residual motion, such as residual acceleration from inertia of the haptic actuator. The residual motion may also be referred to as an oscillatory tail, and the braking may be used to reduce or eliminate the oscillatory tail. Switching from the open-loop control to the closed-loop control allows the driving portion to be improved and/or optimized toward creating movement for the haptic actuator, and the braking portion to be improved and/or optimized toward stopping movement for the haptic actuator. More particularly, a single function (e.g., transfer function) or other algorithm (also referred to as control technique) that is improved and/or optimized toward creating movement for the haptic actuator may focus on creating a drive signal that quickly ramps up movement (e.g., acceleration) for a haptic actuator, but this single function may lead to a long oscillatory tail or sub-optimal braking. Attempting to adjust the single function or other algorithm to improve and/or optimize braking and to reduce the oscillatory tail may, on the other hand, lead to a drive signal that causes movement of the haptic actuator to ramp up too slowly. Switching between the open-loop control and closed-loop control may address this issue by employing a function or other algorithm to optimize driving of the haptic actuator, such as by quickly ramping up movement of the haptic actuator, and then switching to a different algorithm (or, more generally, a different technique) when braking needs to be performed, wherein this latter algorithm is improved and/or optimized for braking. As a result, the former algorithm no longer has to attempt to balance driving the haptic actuator with braking of the haptic actuator, and thus can be focused toward improving and/or optimizing driving the haptic actuator. In one example, the former algorithm may employ open-loop control to generate the square wave, which may be improve and/or optimized for quickly creating movement by the haptic actuator, because the square wave can cause the haptic actuator to output large peak-to-peak acceleration, and to reduce and/or minimize an amount of rise time needed for the acceleration to ramp up from zero. Although the square wave may cause a long oscillatory tail in a haptic actuator such as an LRA (which may have low damping), a separate algorithm may employ closed-loop control to cause an acceleration of such residual movement to converge toward zero, or more generally to brake the haptic actuator.

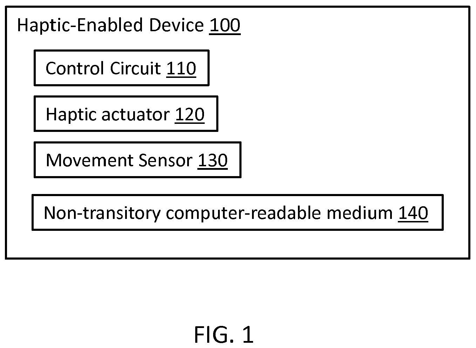

FIG. 1 illustrates a haptic-enabled device 100 that is configured to use a hybrid form of control to generate a haptic effect with a haptic actuator 120. The haptic-enabled device may be, e.g., a mobile phone, laptop computer, tablet computer, vehicle user interface device, wearable device (e.g., a watch), or any other haptic-enabled device. The haptic-enabled device 100 may include the haptic actuator 120, a control circuit 110 that is configured to control the haptic actuator 120, a movement sensor 130, and a non-transitory computer-readable medium 140.

In an embodiment, the haptic actuator 120 may be a linear resonant actuator (LRA), a linear motor, an eccentric rotating mass (ERM) actuator, a solenoid resonating actuator (SRA), a piezoelectric actuator, an electroactive polymer (EAP) actuator, or any other type of haptic actuator. In an embodiment, the haptic-enabled device 100 may have a housing that includes other components of the haptic-enabled device 100, and the haptic actuator 120 may be mounted to the housing, or embedded within a portion of the housing. In an embodiment, the haptic-enabled device 100 may have a display device, and the haptic actuator 120 may be attached to the display device, or embedded within the display device. In some cases, the haptic-enabled device 100 may have a rigid component, and the haptic actuator 120 may be embedded in the rigid component. In some cases, the haptic-enabled device 120 includes a touchpad or touchscreen that is suspended on a mounting surface via a suspension, and the haptic actuator is attached to the touchpad or touchscreen.

In an embodiment, the control circuit 110 may be configured to generate a drive signal to drive the haptic actuator 120. In some instances, the control circuit 110 may include an amplifier, or more generally a drive circuit, that is configured to generate the drive signal. In an embodiment, the control circuit 120 may include one or more processors or processor cores, a programmable logic array (PLA) or programmable logic circuit (PLC), a field programmable gate array (FPGA), an application specific integrated circuit (ASIC), a microcontroller, or any other control circuit. If the control circuit 120 includes a processor, the processor may be a general purpose processor, such as a general purpose processor on a mobile phone or other end user device, or may be a processor dedicated to generating haptic effects. In an embodiment, the control circuit 110 may be configured to control the haptic actuator 120 based on data from the movement sensor 130.

In an embodiment, the movement sensor 130 may be configured to measure or otherwise sense displacement, speed, acceleration, or some other characteristic of movement being output by the haptic actuator 120. In one example, the movement sensor 130 may be a position sensor (e.g., a potentiometer) that is configured to sense displacement output by the haptic actuator 120. In one example, the movement sensor 130 may be an acceleration sensor 130 (also referred to as an accelerometer) configured to sense acceleration being output by the haptic actuator 120. For instance, the movement sensor 130 may be or may include a spring-mass-based acceleration sensor, a piezoelectric-based accelerometer sensor, a micro-machined micro-electrical-mechanical (MEMS) acceleration sensor, or any other type of acceleration sensor. In an embodiment, if the movement sensor 130 is an acceleration sensor, the haptic-enabled device 100 may include a second sensor that replaces or augments the acceleration sensor. For example, the second sensor may be a position sensor (e.g., a sensing coil), an electrical current sensor, a zero crossing sensor, or any other sensor.

In an embodiment, the non-transitory computer-readable medium 140 may store instructions that can be executed by the control circuit 110, and/or may store a model of a haptic actuator or a parameter value of a haptic parameter. The non-transitory computer-readable medium 140 may include, e.g., a dynamic random access memory (DRAM), a solid state drive (SSD), a hard disk drive (HDD), a tape drive, or any other storage device.

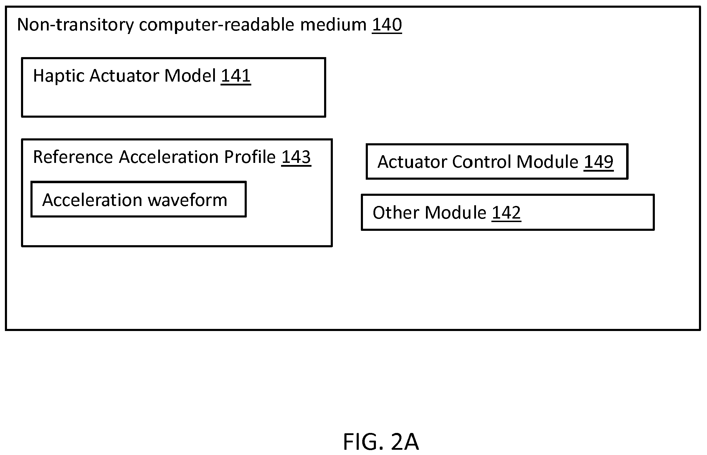

In an embodiment, desired movement for the haptic effect may be defined by information stored on the haptic-enabled device 100, or more specifically stored on the non-transitory computer-readable medium 140. For instance, the information may be a reference profile that describes the desired movement as a function of time. FIG. 2A depicts an example in which the reference profile is a reference acceleration profile 143. The reference acceleration profile may include or describe a time-dependent acceleration waveform, which may also be referred to as $a_{desired}(t)$.

In the example of FIG. 2A, the non-transitory computer-readable medium 140 further stores a model 141 of the haptic actuator 120, as well as an actuator control module 149, and another module 142 (e.g., a game application). In an embodiment, the model 141 may approximate or otherwise describe transient behavior of the haptic actuator 120. The transient behavior may involve electrical and/or mechanical properties of the haptic actuator 120. In some cases, the model 141 may have been determined by a manufacturer of the haptic actuator 120, or by a manufacturer of a device, such as a laptop or laptop touchpad, that incorporates the haptic actuator 120. The model 141 may be stored by the manufacturer directly on the haptic actuator 120 or the non-transitory computer-readable medium 140, or may have been made available for download over the Internet.

In an embodiment, the model 141 may include respective parameter values of parameters that describe a mechanical property or electrical property of the haptic actuator. For instance, the parameters may be an electrical inductance, electrical resistance, mass or moment of inertia, and damping factor of the haptic actuator 120. In some cases, the model 141 may describe components of the haptic actuator 120, such as a spring or electromagnetic coil, and/or a structure of the haptic actuator.

In some instances, the model 141 may be a simplified representation of the components or properties of the haptic actuator 120. For example, the model may assume that an effect of inductance or inertia of the haptic actuator is negligible, which may allow the model 141 to ignore second-order or higher-order effects that may be caused by the inductance or inertia of the haptic effect, and to represent only first order effects that may be caused by other components or properties of the haptic actuator 120.

As stated above, the model 141 may describe transient behavior of the haptic actuator 120, which may also be referred to as transient characteristics or transient dynamics. In such an example, the model 141 may be referred to as a transient model for the haptic actuator 120. The transient behavior for a particular haptic actuator may describe, e.g., how quickly the haptic actuator responds to a drive signal. In some cases, such a transient behavior may be described through one or more inertial properties of the haptic actuator that buffer a reaction of the haptic actuator against an input (e.g., against a drive signal). The inertial properties may include or be based on an electrical transient characteristic of the haptic actuator, and/or a mechanical or electromechanical transient characteristic of the haptic actuator. The electrical transient characteristic may describe, e.g., how long the haptic actuator takes to begin drawing electrical current or changing an amount of electrical current being drawn in response a voltage drive signal or other input. More specifically, the electrical transient characteristic may in one example describe an electrical inductance that creates a time lag between a start of a voltage input signal and flow of electrical current into the haptic actuator. The mechanical or electromechanical transient characteristic may describe, e.g., how long the haptic actuator takes to output movement or a change in movement in response a force or torque being generated within the haptic actuator, such as a force or torque generated from electrical current drawn into the haptic actuator. For instance, the mechanical or electromechanical transient characteristic may describe a moment of inertia that creates a lag between a start of a force or torque that is created by the electrical current and outputting of movement by the haptic actuator. In an embodiment, the model 141 may further include information that describes steady state behavior of the haptic actuator 121 in addition to or instead of transient behavior.

In an embodiment, the model may include an inverse transfer function $T^{-1}$, such as a function describing $T^{-1} = \dfrac{d(t)}{a_{desired}(t)}$ or $T^{-1} = \dfrac{d(s)}{a_{desired}(s)}$, wherein $d(t)$ is the drive signal in the time domain, $a_{desired}(t)$ is a desired acceleration in the time domain, $d(s)$ is the drive signal in the Laplace domain, and $a_{desired}(s)$ is the desired acceleration in the Laplace domain. When the model includes an inverse transfer function, it may also be referred to as an inverse model. Models for a haptic actuator are described in more detail in U.S. Provisional Application No. 62/622,648, entitled "Method of Actuator Control based on Characterizing of Haptic Actuator," and in U.S. Patent Application No. 16/250,494, entitled "Method and Device for Performing Actuator Control based on an Actutaor Model," the entire contents of which are incorporated herein by reference.

In an embodiment, the model 141 may describe a behavior of only the haptic actuator 120, or may also take into account a structure in which the haptic actuator 120 is embedded, or to which the haptic actuator 120 is attached. For instance, if the haptic-enabled device 100 includes a touchpad, and the haptic actuator 120 is attached to a touchpad that is in turn mounted to a mounting surface via an elastic suspension, the model 141 may take into account the effects of the touchpad and the elastic suspension on the behavior of the haptic actuator 120. In such an instance, the model 141 may have been determined after the haptic actuator 120 that has already been attached to the touchpad or other structure, and may have been determined by a manufacturer of the laptop or other haptic-enabled device.

As depicted in FIG. 2A, the non-transitory computer-readable medium 140 may further store an actuator control module 149 and at least one other module 142. In an embodiment, the other module 142 may be a game application, a texting application, or some other application that can be executed on the haptic-enabled device 100. In an embodiment, the module 142 may be configured to encounter an event that triggers a haptic effect, such as a virtual button on the haptic-enabled device 100 being clicked or otherwise being touched. The virtual button may be, e.g., an image of a button being displayed on a display device (if one is included) of the haptic-enabled device 100. In such an example, the module 142 may request the actuator control module 149 to generate a haptic effect to simulate a button click. In an embodiment, the module 142 may specify desired movement (e.g., desired acceleration) for the haptic effect. For example, the desired movement may be desired acceleration defined by the reference acceleration profile 143, and more specifically by a time-varying acceleration waveform (also referred to as a time-dependent acceleration waveform) described by the reference acceleration profile 143.

In some cases, the acceleration waveform in the reference acceleration profile 143 may have been experimentally determined at an earlier time, and then stored directly on the non-transitory computer-readable medium 140, or made available for downloading onto the non-transitory computer-readable medium 140 (e.g., via the Internet). For instance, the acceleration waveform may have been experimentally derived from a mechanical button, by measuring acceleration of the mechanical button as the mechanical button is clicked or otherwise actuated by a user. The values of the measured acceleration may be recorded, and may reflect, e.g., vibration or other movement of the mechanical button as it is clicked. The recorded values may form the acceleration waveform, which may eventually be stored on the non-transitory computer-readable medium 140 as part of the reference acceleration profile 143. When a virtual button of the haptic-enabled device 100 is clicked by a user, for example, the actuator control module 149 may attempt to use the haptic actuator 120 to reproduce the acceleration waveform, which may also be referred to as tracking the acceleration waveform, in an effort to simulate a sensation of the mechanical button being clicked, as part of a tracking functionality provided by a hybrid form of control.

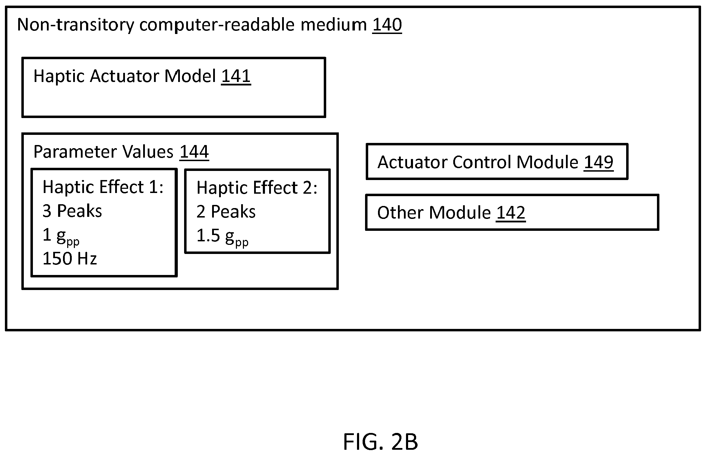

As discussed above, the hybrid form of control may in an embodiment provide a replication functionality, in which a haptic actuator (e.g., 120) is controlled to output movement that follows a desired parameter value for a haptic parameter. The haptic parameter(s) used for the replication functionality may augment or replace the reference acceleration profile 143 of the tracking functionality. FIG. 2B illustrates an embodiment of parameter values 144 of various haptic parameters used for the replication functionality. Similar to FIG. 2A, the non-transitory computer-readable medium 140 in FIG. 2B includes the model 141 of the haptic actuator 120 and includes the actuator module 149 and the other module 142. In FIG. 2B, the non-transitory computer-readable medium 140 further stores parameter values 144 for one or more haptic parameters. In some instances, a particular haptic parameter may identify, e.g., a number of peaks in a variable (e.g., velocity or acceleration) that indicates how much movement a haptic actuator (e.g., 120) is to output for a haptic effect over a duration of the haptic effect. In some instances, a particular haptic parameter may identify an amplitude of the movement that a haptic actuator is to output for the haptic effect, or a frequency content in that movement. In an embodiment, the parameter values 144 may be divided into or otherwise associated with specific haptic effects. For instance, FIG. 2B depicts some of the parameter values 144 being associated with a first specific haptic effect labeled Haptic Effect 1, and some of the parameter values 144 being associated with a second specific haptic effect labeled Haptic Effect 2. More particularly, Haptic Effect 1 includes respective parameter values for three haptic parameters. These haptic parameters indicate a total number of peaks in acceleration that is to be output by a haptic actuator for the haptic effect (e.g., 3 peaks), an amplitude of the acceleration (e.g., a maximum peak-to-peak acceleration of 1 $g_{pp}$), and a frequency content for the acceleration (e.g., a frequency content that includes 150 Hz). Similarly, Haptic Effect 2 includes respective parameter values for two haptic parameters. These haptic parameters also indicate a total number of peaks in acceleration that is to be output by a haptic actuator for the haptic effect (e.g., 2 peaks), and an amplitude of the acceleration (e.g., 1.5 $g_{pp}$).

In an embodiment, the module 142 in FIG. 2B may request that the actuator control module 149 generate a haptic effect having respective parameter values stored as Haptic Effect 1 or as Haptic Effect 2. The actuator control module 149 may retrieve the parameter values associated with Haptic Effect 1 or Haptic Effect 2. In some cases, the actuator control module 149 may generate a driving portion of a drive signal based on the parameter values, and apply the driving portion to the haptic actuator 120. The driving portion may be generated further based on the model 141 of the haptic actuator 120, or may be generated without use of the model 141. In some cases, the actuator control module 149 may subsequently generate a braking portion after the driving portion has been applied to the haptic actuator.

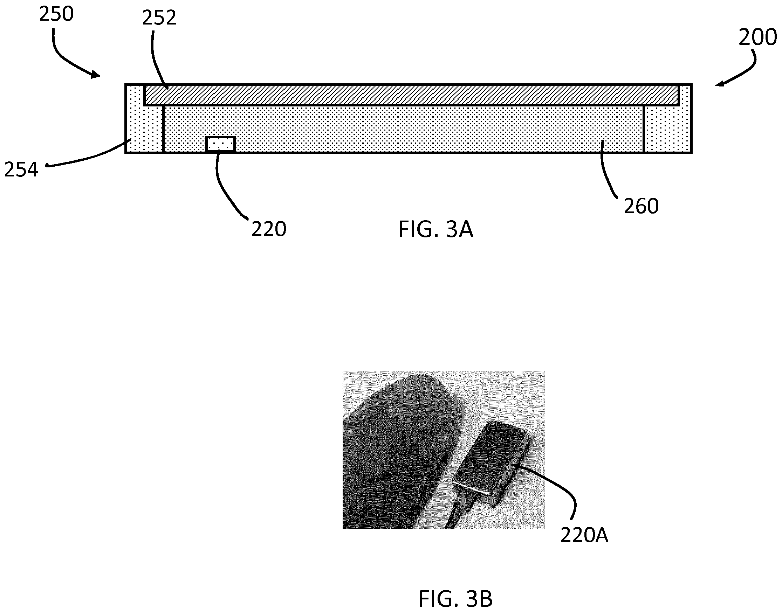

In an embodiment, the haptic-enabled device 100 of FIG. 1 may be a mobile phone, a laptop, or any other user interface device. FIG. 3A illustrates a mobile phone 200 that is configured to generate a haptic effect using, e.g., the hybrid form of control discussed above. The mobile phone 200 may be an embodiment of the haptic-enabled device 100. As depicted in FIG. 3A, the mobile phone 200 includes a housing 250 that is formed by a touchscreen 252 and a shell 254, such as a plastic shell or metal shell. In an embodiment, the mobile phone 200 may further include a circuit board 260 or other substrate, and may include a haptic actuator 220 that is embedded in the circuit board 260 or other substrate. In such an arrangement, when the haptic actuator 220 outputs a vibration or other movement, the vibration may be transferred to the circuit board 260, and/or the housing 250 of the mobile phone 200. The circuit board 260 may further be a rigid component that has a low degree of elasticity. The rigidity of the circuit board 260 may facilitate transfer of the vibration from the haptic actuator 220 to the circuit board 260 and to the housing 250 of the mobile phone 200. FIG. 3B illustrates an example in which the haptic actuator 220 of FIG. 3A is a haptic actuator 220A having dimensions of 1 cm x 2.5 cm. The haptic actuator 220A may be, e.g., a Nidec® Sprinter Gamma® motor embedded in a 100g cube. In an embodiment, the hapic actuator 220A may form a rigid object, and may be embedded in the mobile phone without any suspension (so as not to create any additional resonant frequency that may arise from the suspension).

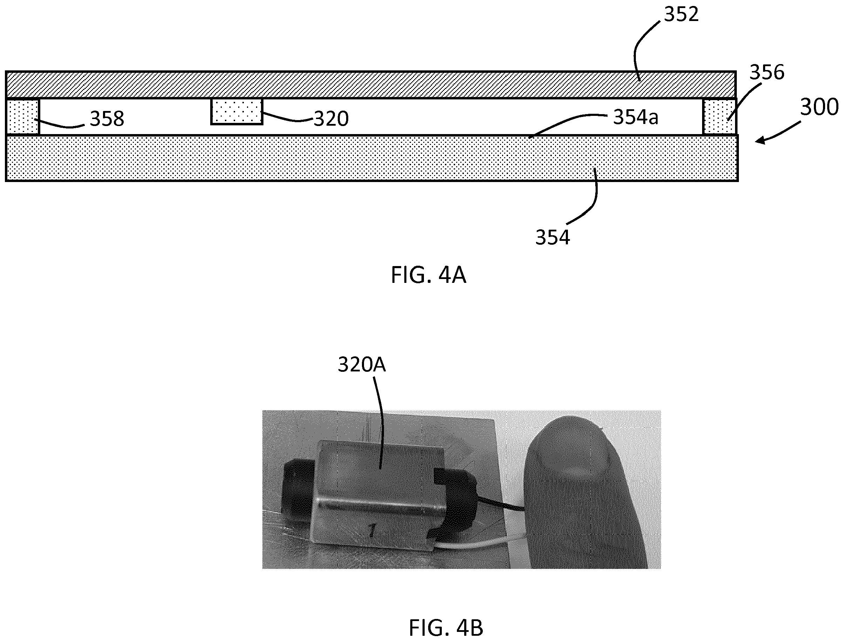

FIG. 4A depicts a user interface device 300 that is an embodiment of the haptic-enabled device 100. The user interface device 300 may be, e.g., a laptop or a vehicle-mounted user interface device (e.g., a center console device). The user interface device 300 incorporates a touchscreen or touchpad 352 and a mounting component 354. The mounting component 354 may be, e.g., part of a housing of a laptop, or part of a mounting block that is part of a body of a vehicle. In some instances, the touchscreen or touchpad 352 may be suspended over a mounting surface 354a of the mounting component 354. In some cases, the touchpad 352 may be suspended via suspension components 356, 358, which may form an elastic suspension, such as a spring suspension, for example. In an embodiment, a haptic actuator 320 may be mechanically or chemically attached to a back surface of the touchscreen or touchpad 352. FIG. 4B depicts an example in which the haptic actuator 320 is a Nidec® HT-6220 motor 320A.

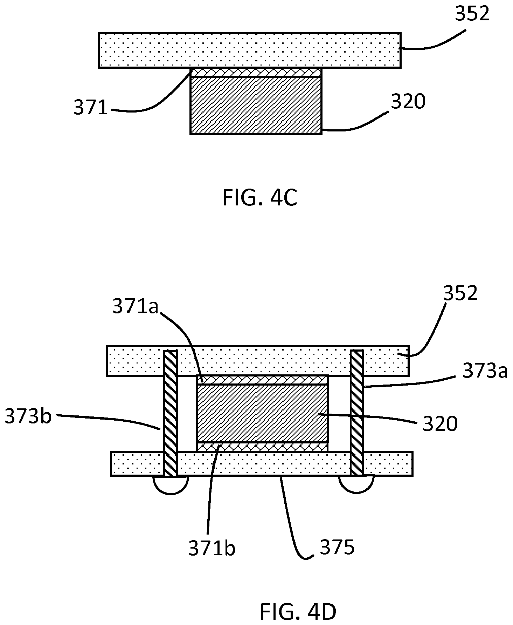

FIGS. 4C-4E depict various ways in which the haptic actuator 320 and the touchscreen or touchpad 352 can be connected to each other. In FIG. 4C, the haptic actuator 320 may be attached to the touchpad 352 via only a layer 371 of adhesive. Such a connection, however, may be relatively loose, especially in embodiments where the haptic actuator 320 is able to generate a sufficiently large amount of acceleration or other measure of movement. This loose connection may allow the haptic actuator 320 to rattle relative to the touchscreen or touchpad 352 when the haptic actuator 320 is outputting acceleration or other movement, which may create unwanted audible noise.

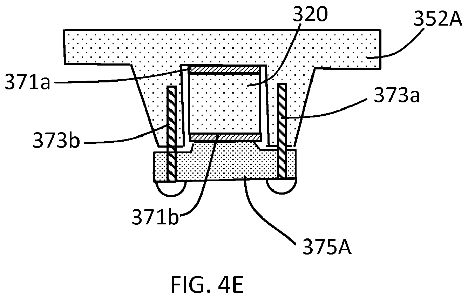

FIGS. 4D and 4E illustrate embodiments in which one or more mechanical fasteners may also be used to clamp the haptic actuator 320 to the touchscreen or touchpad 352, so as to provide a stronger connection (e.g., more rigid connection) between the haptic actuator 320 and the touchscreen or touchpad 352 and thus reduce or eliminate audible noise. More specifically, FIG. 4D illustrates an embodiment in which the haptic actuator 320 is clamped against the touchscreen or touchpad 352 via a clamping plate 375 and one or more mechanical fasteners 373a, 373b (e.g., screws). The haptic actuator 320 may further be connected to the touchscreen or touchpad 352 via a first layer 371a of adhesive, and connected to the clamping plate 375 via a second layer 371b of adhesive. The clamping from the mechanical fasteners 373a, 373b may significantly reduce rattling and rotation of the haptic actuator 320 relative to the touchpad 352 when the haptic actuator 320 is outputting movement. As a result, the clamping may significantly reduce unwanted audible noise and improve transmission of vibration or other movement from the haptic actuator 320 to the touchpad 352.

Like the embodiment of FIG. 4D, the embodiment of FIG. 4E illustrates attachment of the haptic actuator 320 to a touchpad 352A, which is an embodiment of the touchpad 352. The embodiment of FIG. 4E further includes a clamping plate 375A, which may be an embodiment of the clamping plate 375. The touchpad 352A may be shaped to receive or otherwise substantially fit around the haptic actuator 320. For instance, the touchpad 352A may have a cavity that is shaped to receive the haptic actuator 320. Such a configuration of the touchpad 352A may funnel movement of the haptic actuator 320 along only one axis, such as an axis that is perpendicular to a surface of the touchpad 352A. This configuration may reduce or eliminate rattling or other movement of the haptic actuator along an axis parallel to the surface of the touchpad 352A.

As stated above, one aspect of the embodiments herein relates to using a hybrid form of control that combines open-loop control and closed-loop control.

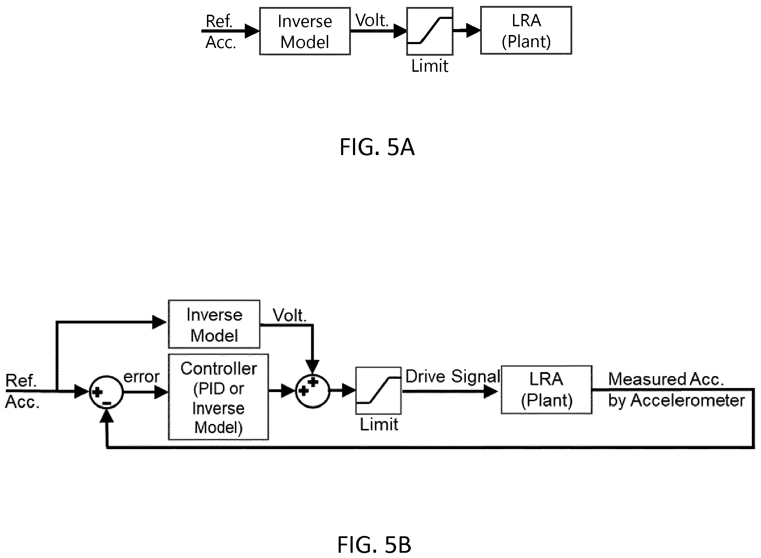

FIG. 5A depicts a representation of using only open-loop control to drive a haptic actuator, or more specifically a linear resonant actuator (LRA), which is referred to as a plant in FIG. 5A. The open-loop control in FIG. 5A is based on controlling acceleration, and may involve using an inverse model to output a voltage signal or other drive signal based on a desired acceleration (also referred to as reference acceleration), which may be an input to the inverse model. The inverse model may be a model of the haptic actuator (e.g., haptic actuator 120) that includes an inverse transfer function $T^{-1}$, which is described above. FIG. 5A further illustrates a limiting component disposed between an output of the inverse model (which outputs a drive signal) and the LRA. The limiting component may be configured to prevent any signal value (e.g., voltage value or electrical current value) of the drive signal that is too high in magnitude from being applied to the LRA. The signal value may be too high when it is higher in magnitude than a defined maximum signal value (e.g., defined maximum voltage value or defined maximum current value). In some instances, the defined maximum voltage value or defined maximum current value may be a defined rated maximum voltage value or defined rated maximum current value. In an embodiment, the defined rated maximum voltage value or defined rated maximum current value may be maximum values at which the LRA or other haptic actuator can be sustainably operated without overheating.

As also discussed above, using a hybrid form of control may provide more robust actuator control using only open-loop. The hybrid form of control may be provided by, e.g., the control circuit 110 of FIG. 1. FIG. 5B depicts a representation of a hybrid form of control in which a haptic actuator (e.g., haptic actuator 120), which is referred to as a plant, is controlled with a combination of open-loop control and closed-loop control. The open-loop control may still involve generating a voltage signal from an inverse model and a reference acceleration, as discussed above with respect to FIG. 5A. In an embodiment, the voltage signal may have been calculated ahead of time and stored (e.g., in the non-transitory computer-readable medium 140), rather than calculated in real-time. The stored voltage signal may be associated with a particular reference acceleration, and may later be retrieved when a haptic effect based on the reference acceleration is desired.

The closed-loop control in FIG. 5B may involve adjusting the voltage signal based on feedback from an acceleration sensor (e.g., acceleration sensor 130). More specifically, the acceleration sensor may measure an acceleration that is being output by the plant, wherein the acceleration may also be referred to as a measured acceleration. The closed-loop control may calculate an acceleration error that is equal to a difference between the reference acceleration (e.g., a desired acceleration) and the measured acceleration. More particularly, the acceleration error at a particular instance in time may have a value equal to a difference between a value of the reference acceleration for that instance in time and a value of the measured acceleration for that instance in time. The closed-loop control may, e.g., adjust the voltage signal based on the acceleration error, so as to generate an adjusted signal that is applied to the LRA. In an embodiment, the adjustment may be based on, e.g., a proportional, proportional-derivative (PD), or proportional-integral-derivative (PID) control. In an embodiment, the inverse model may be updated based on the closed-loop control. For instance, the inverse model may be updated so that, when the inverse model is used again to generate a voltage signal for the reference acceleration, the inverse model will output the adjusted drive signal.

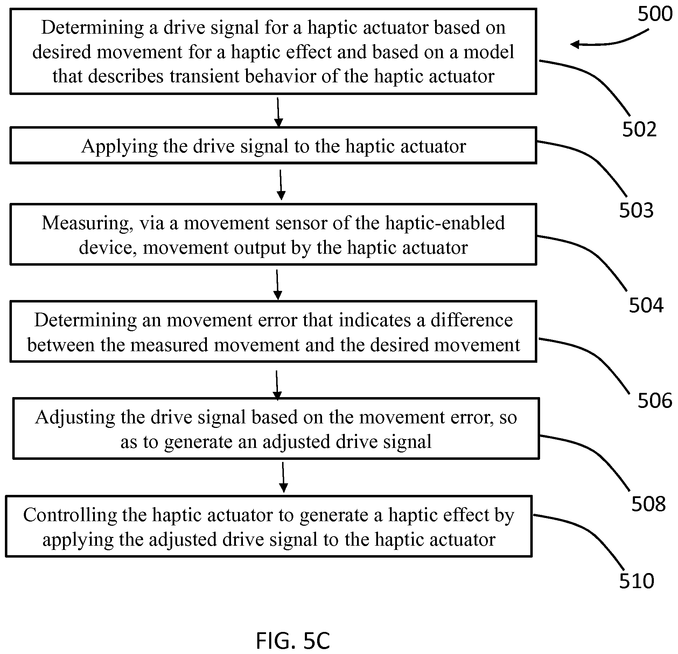

FIG. 5C provides a flow diagram that illustrates an example method 500 for generating a haptic effect by the haptic actuator 120 of the haptic-enabled device 100. The method 500 may be performed by, e.g., the control circuit 110. In an embodiment, the method begins at step 502, in which the control circuit 110 determines a drive signal for a haptic actuator based on desired movement (e.g., desired velocity or desired acceleration) for a haptic effect and based on a model that describes transient behavior of the haptic actuator. Step 502 may be performed using open-loop control, in which a drive signal is generated based on desired movement and a defined, pre-existing function that is able to convert the desired movement to a drive signal, wherein the defined function may be based on a model of the haptic actuator 120.

In an embodiment, the desired movement may be defined by information stored on the haptic-enabled device, such as information stored on the non-transitory computer-readable medium 140 of the haptic-enabled device 100. The desired movement may be referred to as a reference profile of the haptic effect, such as the reference acceleration profile 143 of FIG. 2A. In some cases, the desired movement may be a function of time, and may be defined by a time-dependent waveform, which may also be referred to as a time-dependent function. For instance, if the desired movement for a haptic effect involves desired acceleration, the information on the haptic-enabled device 100 may be a time-dependent acceleration waveform, which may be referred to as $a_{desired}(t)$. In an embodiment, the information that describes a time-dependent waveform may be a plurality of sample values stored on the non-transitory computer-readable medium 140. In such an embodiment, each sample value may represent a portion (e.g., a 10 ms portion) of a duration of the haptic effect.

In an embodiment, the model may be the same as or similar to the model 141 of FIG. 2A. The model may describe, e.g., an electrical transient behavior of the haptic actuator 120 and/or a mechanical or electromechanical transient behavior of the haptic actuator 120, as described above. In an embodiment, the model describes a relationship between drive signal (e.g., voltage signal $v(t)$) and resulting movement (e.g., acceleration $a(t)$) that the haptic actuator 120 is predicted to generate in response to the drive signal. In some cases, the model may define an inverse transfer function that relates the drive signal (e.g., v(t)) as an output of the inverse transfer function based on the desired movement (e.g., $a_{desired}(t)$) as an input to the inverse transfer function. As an example, the model in step 502 may include the inverse transfer function $T^{-1} = \dfrac{d(t)}{a_{desired}(t)}$ or $T^{-1} = \dfrac{d(s)}{a_{desired}(s)}$. In such an example, step 502 may involve inputting a function that represents desired movement, such as $a_{desired}(t)$, into the inverse transfer function so as to yield a voltage signal or other drive signal.

In step 503, the control circuit 110 applies the drive signal to the haptic actuator 120. In an embodiment, step 503 may involve an amplifying circuit or buffer circuit. For instance, the control circuit 110 may output sample values that are signal values for the drive signal. The sample values may be outputted to the amplifying circuit, which may be configured to output, to the haptic actuator 120, voltage values or current values matching the sample values.

In step 504, the control circuit 110 measures, via the movement sensor 130 of FIG. 2A, movement output (e.g., being output) by the haptic actuator 120, wherein the movement is based on the drive signal. In some cases, the control circuit 110 measures the movement as the drive signal is being applied to the haptic actuator 120. The step determines a measured movement of the haptic actuator. In an embodiment, the movement may be measured over time, and the measured movement may be a waveform that include values for that movement sampled at different instances in time. For instance, the movement sensor may be an acceleration sensor, and the movement that is measured in step 504 may be acceleration output by the haptic actuator 120 over time. Such a measured acceleration may be a waveform a(t), which may include values of the acceleration sampled at different instances in time.

In step 506, the control circuit 110 determines a movement error that indicates a difference between the measured movement being output by the haptic actuator 120 and the desired movement. For instance, the movement error may be an acceleration error that indicates a difference between the desired acceleration and acceleration being output by the haptic actuator. If step 506 is performed at a particular instance in time $t_1$, the acceleration error may be determined as $a_{desired}(t=t_1)$ minus $a(t=t_1)$.

In step 508, the control circuit 110 adjusts the drive signal based on the movement error (e.g., acceleration error), so as to generate an adjusted drive signal. The adjusted drive signal may thus be based on both (i) the model of the haptic actuator and (ii) an adjustment that compensates against the movement error. Step 508 may include an aspect of closed-loop control, because the adjustment of the drive signal is based on the movement being currently being output by the haptic actuator 120, or more specifically based on a current movement error. Further, because the drive signal was initially generated in step 502 based on the model that describes the transient behavior of the haptic actuator 120, the adjusted drive signal in step 508 is based on both the model of the haptic actuator 120 and on the adjustment that compensates against the movement error.

In an embodiment, the control circuit 110 is configured to adjust the drive signal based on a proportion of the acceleration error, so as to provide proportional closed-loop control. For instance, if step 508 is performed at an instance in time $t_1$ the adjustment in step 508 may be based on $k_1 * e(t_1)$, wherein $e(t) = [a_{desired}(t=t_1) - a(t=t_1)]$, wherein $k_1$ is a constant. In an embodiment, the control circuit 110 is configured to adjust the drive signal based on a time-dependent derivative of the acceleration error. For instance, the adjustment may based on $k_2 * de(t_1)/dt$, wherein $k_2$ is another constant. In an embodiment, the control circuit 110 is configured to adjust the drive signal based on a time-dependent integral of the acceleration error. For instance, the adjustment may be based on $k_3 * \int_0^{t_1} e(t)\, dt$, wherein $k_3$ is another constant. In an embodiment, the various adjustments may be combined so as to provide proportional-derivative (PD) control or proportional-integral-derivative (PID) control. In an embodiment, the adjustment may be added or otherwise applied to the drive signal determined in step 502. For instance, if step 508 is performed at time $t_1$, the adjustment may be referred to as $c(t_1)$, and adjusting the drive signal may include calculating $d(t_1) + c(t_1)$, wherein d(t) is the drive signal determined in step 502.

In step 510, the control circuit 110 applies the adjusted drive signal to the haptic actuator 120 to generate a haptic effect. The adjusted drive signal is generated using both open-loop control and closed-loop control, because open-loop control is used in step 502 to generate an initial drive signal, and closed-loop control is used in step 508 to make adjustments to the initial drive signal. The closed-loop control may assist the haptic actuator 120 in outputting movement that matches a desired movement, while the open-loop control may facilitate a speed and accuracy of that matching process by providing an initial drive signal that is already tailored to the transient behavior of the haptic actuator 120 (by being generated based on a model which describes that transient behavior). Such an initial drive signal may need less adjustment to result in a movement which converges toward a desired movement, and thus may lead to a faster adjustment. In an embodiment, steps 502 and 503 may be performed only once for each haptic effect, so as to generate and apply an initial drive signal for the haptic effect, while steps 504 through 510 may be performed multiple times over different instances in time, so as to make adjustments to the drive signal over time. More specifically, steps 504 through 510 may be performed over many cycles or iterations, wherein the ith cycle or ith iteration corresponds to a different respective instance in time, or time $t_i$.

In an embodiment, steps 502 through 510 may be performed in response to the clicking of a virtual button. In such an embodiment, the haptic-enabled device 100 may have an area on its surface that represents a virtual button. The control circuit 110 may be configured to detect that the virtual button of the haptic-enabled device 100 is being clicked or otherwise actuated. In response to detecting such a click, the control circuit 110 may perform steps 502 through 510 to control the haptic actuator 120 to generate a haptic effect corresponding to the virtual button.

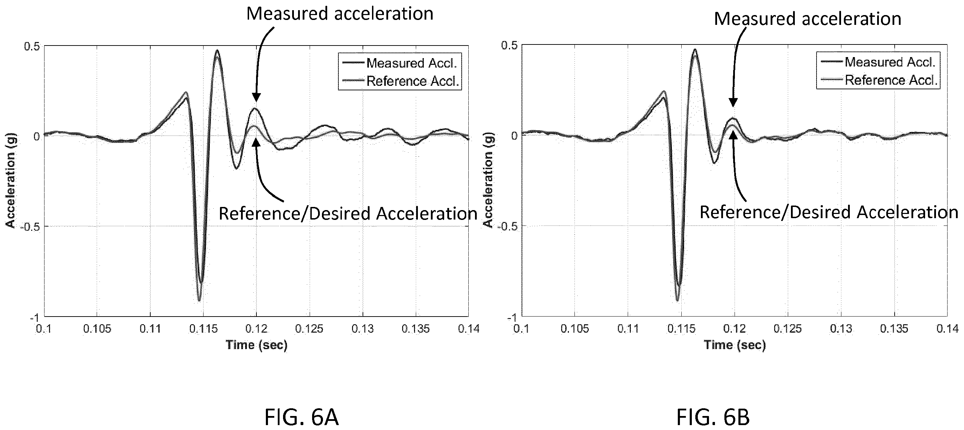

FIG. 6A depicts measured acceleration, which may be referred to as $a_{measured}(t)$ or just $a(t)$, that is generated with only open-loop control. The measured acceleration is further superimposed against a reference acceleration, which may be referred to as $a_{desired}(t)$, in order to show a difference between the reference acceleration and the acceleration that the haptic actuator is able to achieve with only the open-loop control. As depicted in FIG. 6A, $a_{measured}(t)$ has portions with acceleration values that differ from that of $a_{desired}(t)$. FIG. 6B illustrates measured acceleration $a_{measured}(t)$ that is generated with a hybrid form of the open-loop control and the closed-loop control. In FIG. 6B, the combination of the open-loop control and the closed-loop control may provide adjustments that facilitate tracking of $a_{desired}(t)$ by $a_{measured}(t)$. As a result, the measured acceleration $a_{measured}(t)$ generated from the hybrid form of control in FIG. 6B more closely tracks the reference acceleration $a_{desired}(t)$, as compared with the implementation illustrated in FIG. 6A, in which only the open-loop form of control is used.

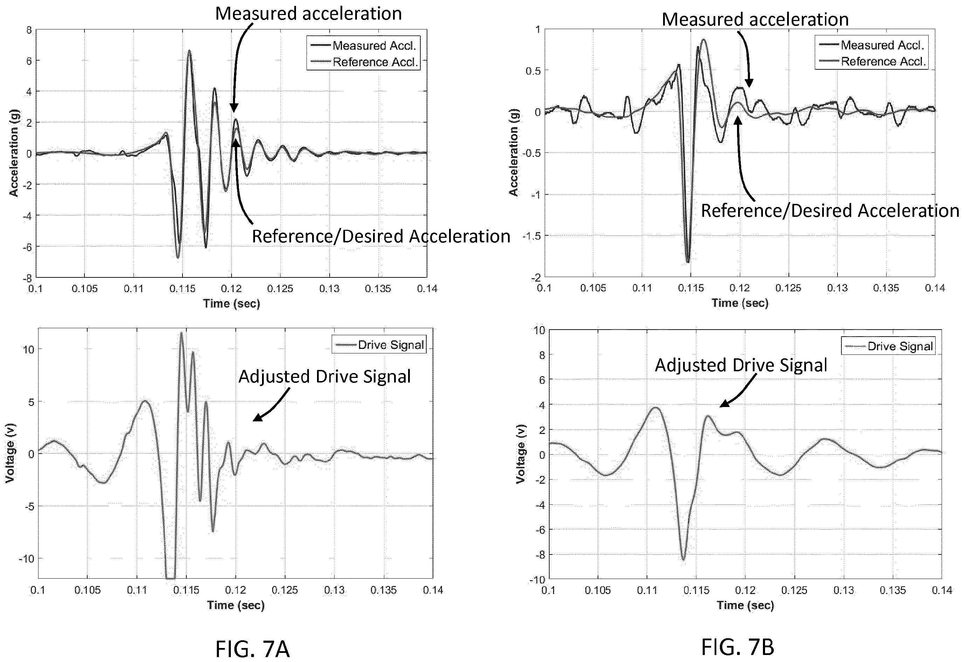

FIG. 7A illustrates an adjusted drive signal that is generated with the hybrid form of control discussed above. The figure further illustrates reference acceleration for a haptic effect and measured acceleration that is output by a haptic actuator (e.g., 120) for the haptic effect. In the example of FIG. 7A, the haptic effect may be intended to simulate the sensation of a buzzy button click. Further, both the reference acceleration and the reference acceleration may have a maximum peak-to-peak amplitude (also referred to as peak-to-peak magnitude) of about 14 $g_{pp}$, and the adjusted drive signal may have a maximum peak-to-peak amplitude of about 24 $V_{pp}$

FIG. 7B depicts another example of an adjusted drive signal that is generated with the hybrid form of control discussed above. In this example, the adjusted drive signal may generate a haptic effect that is intended to simulate a sharp button click. The haptic effect may have a reference acceleration with an amplitude that is about 3 $g_{pp}$. Further, the adjusted drive signal in FIG. 7B may have a maximum amplitude of about 12 $V_{pp}$.

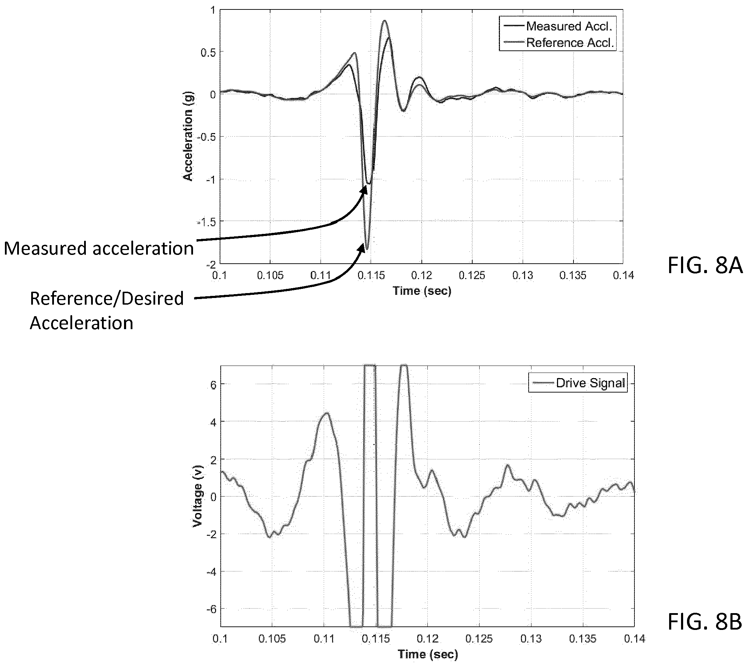

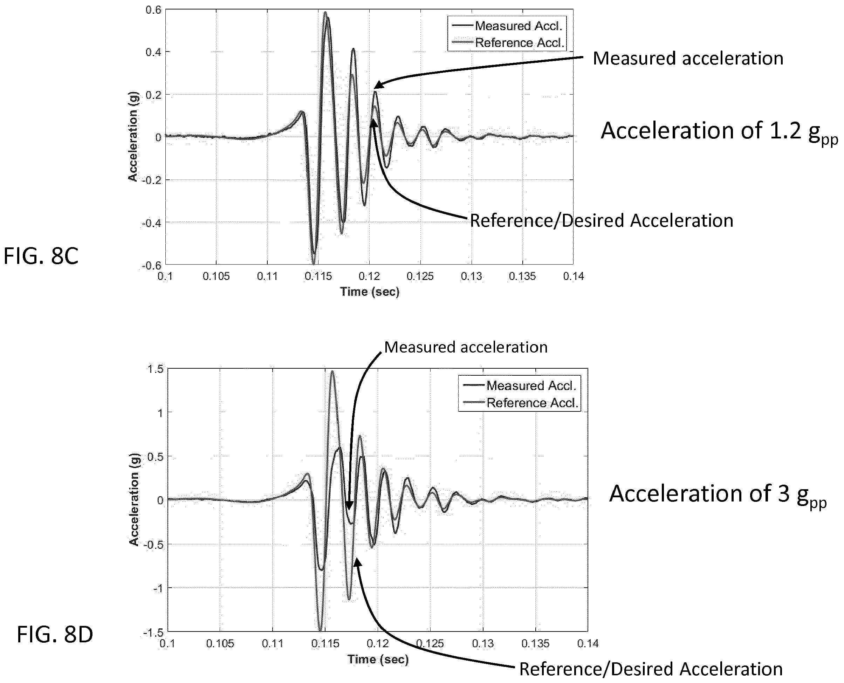

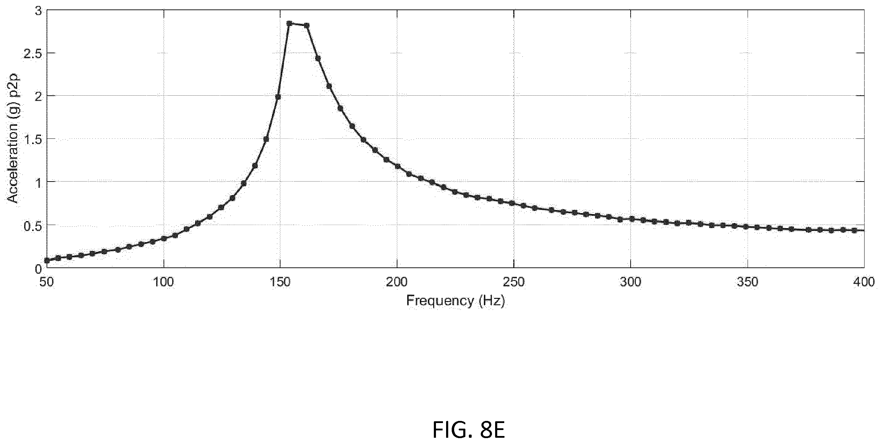

The above figures demonstrate a situation in which an adjusted drive signal generated with the hybrid form of control is able to cause the haptic actuator to output an acceleration that closely matches desired acceleration or other reference acceleration. In some instances, however, the reference acceleration may have peak-to-peak values that are not feasible for a haptic actuator to match, because of hardware limitations on the haptic actuator. For instance, FIG. 8A depicts a situation in which the reference acceleration has a maximum peak-to-peak value of about 3 $g_{pp}$. To drive the haptic actuator to match the reference acceleration may entail an adjusted drive signal that exceeds a defined rated maximum voltage value (e.g., exceeds 7 V) in magnitude. A drive signal with an excessively high voltage value may, however, damage the haptic actuator or create problems in measuring an acceleration being output by the haptic actuator. Thus, as illustrated in FIG. 8B, the adjusted drive signal may be limited to a range between -7 V and 7 V. Such an adjusted drive signal may, however, lead to a measured acceleration that poorly tracks a reference acceleration for a haptic effect. Thus, FIGS. 8A and 8B demonstrate that the hybrid form of tracking may be especially useful or optimal when the drive signal voltage is limited to a particular maximum peak-to-peak amplitude. The maximum peak-to-peak amplitude may more generally be referred to as a feasibility envelope, which defines a range of movement characteristics (e.g., acceleration characteristics) that is feasible for the haptic actuator to track without causing damage to the haptic actuator. For instance, the feasibility envelope may indicate that a particular haptic actuator can feasibly track reference acceleration having a maximum peak-to-peak amplitude of, e.g., less than 2 $g_{pp}$, and that reference accelerations with higher maximum peak-to-peak amplitude may lead to relatively poor tracking by the haptic actuator. FIG. 8C demonstrates an instance in which the reference acceleration being tracked has a maximum peak-to-peak amplitude (e.g., 1.2 $g_{pp}$) that falls within the feasibility envelope. In such an instance, the haptic actuator may output acceleration that achieves relatively close matching to the reference acceleration. FIG. 8D, on the other hand, demonstrates an instance in which the reference acceleration being tracked has a maximum peak-to-peak amplitude (e.g., 3 $g_{pp}$) that falls outside of the feasibility envelope. In such an instance, the haptic actuator may be limited to outputting acceleration that has relatively poor tracking to the reference acceleration. FIG. 8E further depicts an example relationship between maximum peak-to-peak amplitude that a haptic actuator (e.g., haptic actuator 120) is rated to achieve versus frequency content of the acceleration. This example relationship indicates that the feasibility envelope for a haptic actuator may shrink (so as to accommodate a smaller range of acceleration amplitudes) as frequency changes (e.g., increases). In an embodiment, the control circuit 110 may be configured to determine a threshold for an amplitude of the desired movement based on frequency content of the desired movement. If the amplitude exceeds the threshold, the control circuit 110 may be configured to scale the desired movement, such as by scaling a waveform representing the desired movement, to a level that does not exceed the threshold. For instance, FIG. 8E provides an example in which a haptic actuator is rated to achieve a maximum peak-to-peak amplitude of about 0.75 $g_{pp}$ for a frequency of 250 Hz. In such an example, the control circuit may be configured to set a threshold of 0.75 $g_{pp}$ for desired acceleration which includes 250 Hz in its frequency content. If the desired acceleration has an amplitude which exceeds the threshold, the control circuit 110 may be configured to scale the desired acceleration to have an amplitude which is equal to or less than the threshold. In another embodiment, the control circuit may 110 may determine to perform the tracking functionality illustrated in method 500 only if the desired movement has an amplitude which exceeds the threshold discussed above, and may be configured to perform the replication functionality illustrated below (with respect to method 900) only if a parameter value for an amplitude parameter does not exceed the threshold discussed above.

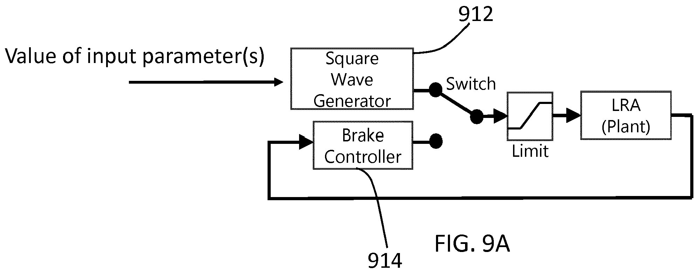

As stated above, one aspect of the embodiments herein relates to providing a replication functionality, in which a haptic actuator outputs acceleration (or other movement) that replicates a parameter value of a haptic parameter, such as one of parameter values 144 of FIG. 2B. For instance, the haptic parameter may be a total number of peaks in acceleration output by the haptic actuator, a maximum peak-to-peak amplitude of the acceleration output by the haptic actuator, or a frequency content of the acceleration output by the haptic actuator. FIG. 9A depicts a hybrid form of control that is configured to generate a driving portion of a drive signal in an open-loop manner, based on a defined function that converts a parameter value to a drive signal, and to generate a braking portion in a closed-loop manner. In an embodiment, the driving portion of the drive signal may be a square wave, and may be generated with a square wave generator 912, as depicted in FIG. 9A. In some cases, the square wave generator may be implemented by the control circuit 110. In an embodiment, the braking portion may be generated by a brake controller 914, which may measure acceleration that is being output by the haptic actuator and generate a drive signal that forces the acceleration to converge toward zero. In an embodiment, the brake controller 914 may be implemented by a control circuit (e.g., 110). As illustrated in FIG. 9A, the control circuit may be configured to switch between acting as a square wave generator 912 and acting as a brake controller 914.

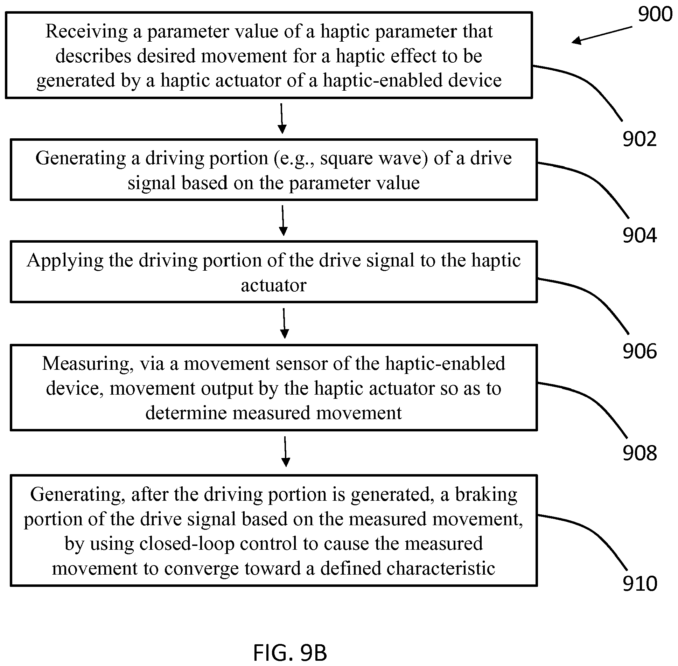

FIG. 9B depicts a method 900 for generating a drive signal to control a haptic actuator to generate a haptic effect. The method 900 may be performed by, e.g., the control circuit 110. In an embodiment, method 900 starts at step 902, in which the control circuit 110 receives a parameter value of a haptic parameter that describes desired movement (e.g., desired acceleration) for a haptic effect to be generated by a haptic actuator of the haptic-enabled device. In an embodiment, the haptic parameter may be an acceleration parameter, and the desired movement described by the haptic parameter is desired acceleration for the haptic effect. For instance, the haptic parameter may be, e.g., a total number of peaks in desired acceleration $a_{desired}(t)$ for the haptic effect, a maximum peak-to-peak amplitude of the desired acceleration, or frequency content for the desired acceleration. In an embodiment, the parameter value may be received from a storage device, such as the non-transitory computer-readable medium 140. Method 900 may involve receiving only the parameter value for the haptic parameter, or may involve receiving multiple parameter values for multiple respective haptic parameters.

In step 904, the control circuit 110 generates a driving portion of a drive signal based on the parameter value. In an embodiment, the driving portion may be a square wave that is generated based on the parameter value of the haptic parameter. For instance, if the haptic parameter indicates a total number of peaks in the desired acceleration for a haptic effect, the square wave generator may generate a square wave having that same number of peaks. If the square wave alternates between $v_o$ and $-v_o$, then each peak may refer to a continuous portion in which the square wave has the value of $v_o$ or the value of $-v_o$. In an embodiment, if the haptic parameter indicates frequency content for the desired acceleration, the square wave generator may generate a square wave having the frequency content of the desired acceleration. In some cases, if the haptic parameter indicates a maximum peak-to-peak amplitude of the desired acceleration, the square wave generator may generate a square wave having a peak-to-peak amplitude $V_{pp}$ that is based on the maximum peak-to-peak amplitude of the desired acceleration. In an embodiment, the square wave that is generated may have a duration that is equal to a duration of the desired acceleration.

In step 906, the control circuit 110 applies the driving portion of the drive signal to the haptic actuator. In some cases, step 906 may be similar to step 503. For instance, step 906 may involve the control circuit 110 outputting values for the driving portion to an amplifying circuit or buffer circuit, which generates appropriate voltage values or electrical current values for the haptic actuator.

In step 908, the control circuit 110 measures, via the movement sensor 130 of the haptic-enabled device 100, movement output (e.g., being output) by the haptic actuator so as to determine a measured acceleration. In an embodiment, the measured movement may include a plurality of values corresponding to different instances in time, and may form a time-varying waveform. The values may belong to a variable that measures the movement, such as acceleration or velocity. For example, the values may be acceleration values that form a time-varying acceleration waveform. In an embodiment, step 908 may be similar to step 504 of FIG. 5C.

In step 910, the control circuit generates, after the driving portion is generated, a braking portion of the drive signal based on the measured movement, by using closed-loop control to cause the measured movement to converge toward a define characteristic, which may be a desired characteristic for the measured movement. For instance, if the measured movement refers to measured acceleration, then the defined characteristic may refer to the measured acceleration moving (e.g., converging) toward zero. In an embodiment, the closed-loop control is based on a time-dependent derivative of the measured acceleration, and/or a time-dependent integral of the acceleration. In another embodiment, steps 908 and 910 may be omitted, and the braking portion may be generated based on impact mechanics.

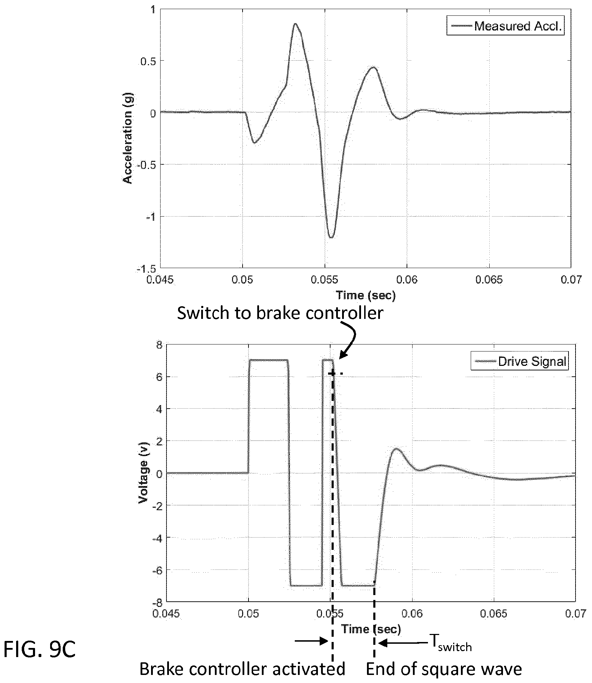

In an embodiment, the control circuit may switch between generating the driving portion and generating the braking portion based on a gap $T_{switch}$, which is illustrated in FIG. 9C. The driving portion may be, e.g., a square wave having a duration of $T_{square}$, which may in some cases be equal to a duration of the desired acceleration. If generating of the driving portion starts at time t=0, then an end time for generating the driving portion may be at $t=T_{square}$. In such an example, the switch to generating the braking portion may occur at $T_{square} - T_{switch}$. That is, the brake controller functionality may be activated before an end of the driving portion (e.g., square wave). The amount by which the brake controller is activated early may be equal to $T_{switch}$. In an embodiment, $T_{switch}$ may be based on the number of peaks in the desired acceleration and a desired frequency content of the desired acceleration. For instance $T_{switch}$ may be equal to $f_1/f_2$, wherein $f_1$ is a function of the number of peaks, and $f_2$ is a function of the frequency content.

In an embodiment, generating the braking portion may be based on proportional-integral-derivative (PID) control, proportional-integral (PI) control, proportional-derivative (PD) control, or integral (I) control with tuned gains. For instance, the brake controller at a time $t_i$ may be configured to adjust a drive signal based on first constant $k_1$ multiplied by an acceleration at time $t_i$, on a second constant $k_2$ multiplied by a derivative of the acceleration at time $t_i$, and/or based on a third constant $k_3$ multiplied by an integral of the acceleration, from a start of the braking portion to time $t_i$.

In an embodiment, generating the braking portion may be based on an impulse signal that is derived from impact mechanics. The impact mechanics may determine an optimal time and force at which to apply an impulse to an oscillating mass to stop the oscillating mass. In some cases, the impulse signal may be based on a velocity being output by the haptic actuator, and on a resistance and mass in a model of the haptic actuator. In an embodiment, the impulse signal may rise quickly, and then decay at an exponential rate that is based on a resistance and inductance identified in the model of the haptic actuator.

In an embodiment, the haptic actuator used for method 900 may be an LRA, which may be well suited for performing the replication functionality. More specifically, the LRA may have a short rise time, which may facilitate replication of certain parameter values. In an embodiment, the LRA may be more suitable to performing the replication functionality than to performing the tracking functionality. Thus, in an embodiment, the tracking functionality of method 500 may use a haptic actuator that is not an LRA (e.g., use an ERM actuator).

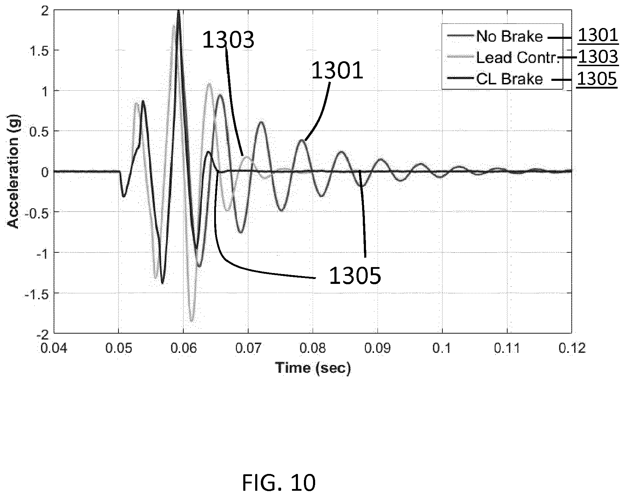

FIG. 10 illustrates waveforms 1301, 1303, 1305 for measured acceleration that is output by a haptic actuator. Waveform 1301 represents acceleration that is output by a haptic actuator in a situation in which a driving portion (e.g., square wave) is generated and applied to the haptic actuator, and no braking portion is generated nor applied to the haptic actuator. In such a situation, the acceleration has an oscillatory tail resulting from inertia of the haptic actuator or of components within the haptic actuator, wherein the inertia causes the haptic actuator to output residual movement. Waveform 1303 represents acceleration that is output by a haptic actuator in a situation in which the driving portion is modified to attempt to reduce an oscillatory tail in the acceleration, and in which no separate algorithm is used to specifically generate a braking portion for the haptic actuator. In such a situation, the driving portion may have to balance between quickly and/or strongly driving the haptic actuator, and avoiding generating too much residual movement. To balance these two goals, the driving portion in this situation may thus sacrifice performance in terms of driving the haptic actuator and/or sacrifice performance in terms of avoiding residual movement. For instance, the driving portion may be designed to sacrifice performance in terms of avoiding residual movement, so as to retain sufficient performance in terms of strongly and quickly driving the haptic actuator. Waveform 1303 illustrates acceleration resulting from such an instance, in which the resulting acceleration still exhibits an oscillatory tail, which results from residual movement from the haptic actuator. As stated above, one aspect of the embodiments herein relates to switching between using a first algorithm to generate a driving portion of a drive signal, and using a second algorithm to specifically generate a separate braking portion of the drive signal. This allows the driving portion to be improved and/or optimized toward quickly and/or strongly driving the haptic actuator, and allows the braking portion to be improved and/or optimized toward quickly braking the haptic actuator. Waveform 1305 illustrates acceleration resulting from driving and braking the haptic actuator in such a manner. In this illustration, the braking portion can be improved and/or optimized specifically toward causing acceleration from the haptic actuator to move (e.g., converge) toward zero, and does not need to balance this goal with a goal of also driving the haptic actuator. The resulting acceleration may thus, as depicted by waveform 1305, have substantially no oscillatory tail.

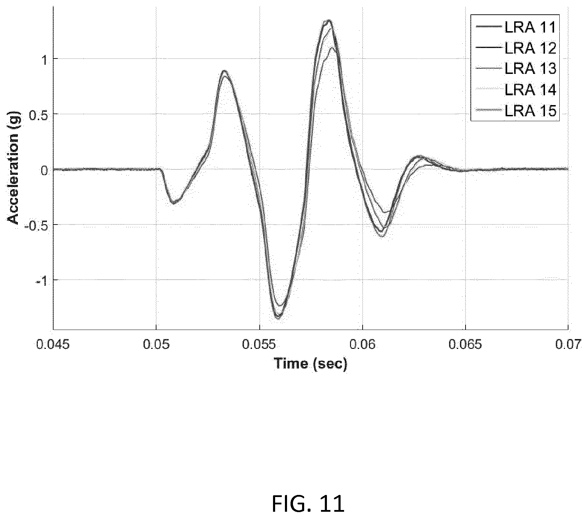

As stated above, one aspect of the embodiments herein relates to compensating against a relaxed manufacturing tolerance, which may cause haptic actuators to have variations among each other. FIG. 11 illustrates respective accelerations generated by different haptic actuators that may have variations among each other, wherein the respective accelerations are generated with the hybrid form of control discussed above (to perform a tracking functionality or replication functionality). As depicted in FIG. 11, the hybrid form of control may overcome variations among different haptic actuators and cause the different haptic actuators to achieve substantially uniform acceleration. Thus, the hybrid form of control may provide more effective and predictable control of haptic actuators.

Additional Discussion of Various Embodiments

Embodiment 1 relates to a haptic-enabled device, comprising: a haptic actuator; a movement sensor; and a control circuit. The control circuit is configured to determine a drive signal for the haptic actuator based on desired movement for a haptic effect and based on a model that describes transient behavior of the haptic actuator, wherein the desired movement is defined by information stored on the haptic-enabled device; to apply the drive signal to the haptic actuator; to measure, via the movement sensor, movement output by the haptic actuator, wherein the movement is based on the drive signal, so as to determine a measured movement of the haptic actuator (the movement may be measured, e.g., as the drive signal is being applied to the haptic actuator); to determine a movement error that indicates a difference between the measured movement being output by the haptic actuator and the desired movement; to adjust the drive signal based on the movement error, so as to generate an adjusted drive signal that is based on both (i) the model of the haptic actuator and (ii) an adjustment that compensates against the movement error; and to apply the adjusted drive signal to the haptic actuator to control the haptic actuator to generate the haptic effect.

Embodiment 2 includes the haptic-enabled device of embodiment 1, wherein the haptic-enabled device is a phone having a rigid component in which the haptic actuator is embedded.

Embodiment 3 includes the haptic-enabled device of embodiment 1 or 2, wherein the haptic-enabled device includes a touchpad or touchscreen that is suspended on a mounting surface via a suspension, wherein the haptic actuator is attached to the touchpad or touchscreen, and wherein the model accounts for the attachment of the haptic actuator to the touchpad or touchscreen.

Embodiment 4 includes the haptic-enabled device of any one of embodiments 1 to 3, wherein the desired movement is desired acceleration for the haptic effect, and wherein the information that defines the desired movement is a time-dependent acceleration waveform.

Embodiment 5 includes the haptic-enabled device of embodiment 4, wherein the movement sensor is an acceleration sensor, wherein the movement that is measured is an acceleration being output by the haptic actuator, and wherein the movement error is an acceleration error that indicates a difference between the desired acceleration and the acceleration being output by the haptic actuator.

Embodiment 6 includes the haptic-enabled device of embodiment 5, wherein the model describes a relationship between drive signals and resulting accelerations that the haptic actuator is predicted to generate in response to the drive signals.

Embodiment 7 includes the haptic-enabled device of embodiment 6, wherein the model defines an inverse transfer function that relates the drive signal as an output of the inverse transfer function based to the desired acceleration as an input to the inverse transfer function.

Embodiment 8 includes the haptic-enabled device of any one of embodiments 5 to 7, wherein the control circuit is configured to adjust the drive signal based on a proportion of the acceleration error.

Embodiment 9 includes the haptic-enabled device of any one of embodiments 5 to 8, wherein the control circuit is configured to adjust the drive signal based on a time-dependent derivative of the acceleration error.

Embodiment 10 includes the haptic-enabled device of any one of embodiments 5 to 9, wherein the control circuit is configured to adjust the drive signal based on a time-dependent integral of the acceleration error.

Embodiment 11 includes the haptic-enabled device of any one of embodiments 1 to 10, wherein the control circuit is configured to detect that a virtual button of the haptic-enabled device is being clicked, and to control the haptic actuator to generate the haptic effect in response to detecting the virtual button of the haptic-enabled device being clicked.

Embodiment 12 relates to a haptic-enabled device, comprising: a haptic actuator; a movement sensor; and a control circuit. The control circuit is configured to receive a parameter value of a haptic parameter that describes desired movement for a haptic effect to be generated by the haptic actuator; to generate a driving portion of a drive signal based on the parameter value; to apply the driving portion of the drive signal to the haptic actuator; to measure, via the movement sensor, movement output by the haptic actuator so as to determine a measured movement of the haptic actuator; to generate, after the driving portion is generated, a braking portion of the drive signal based on the measured movement, by using closed-loop control to cause the measured movement to converge toward a defined characteristic.

Embodiment 13 includes the haptic-enabled device of embodiment 12, wherein the haptic parameter is an acceleration parameter, and the desired movement described by the haptic parameter is desired acceleration for the haptic effect.

Embodiment 14 includes the haptic-enabled device of embodiment 13, wherein the movement sensor is an acceleration sensor, and the measured movement is a measured acceleration of the haptic actuator, and wherein the control circuit is configured to generate the braking portion by using closed-loop control to cause the measured acceleration to converge toward zero.

Embodiment 15 includes the haptic-enabled device of embodiment 14, wherein the closed-loop control is based on a time-dependent derivative of the measured acceleration.

Embodiment 16 includes the haptic-enabled device of any one of embodiments 14 or 15, wherein the closed-loop control is based on a time-dependent integral of the measured acceleration.

Embodiment 17 includes the haptic-enabled device of any one of embodiments 13 to 16, wherein the haptic parameter defines at least one of: (i) a total number of peaks in the desired acceleration, (ii) a maximum peak-to-peak magnitude of the desired acceleration, or (iii) a frequency content for the desired acceleration.

Embodiment 18 includes the haptic-enabled device of embodiment 17, wherein the driving portion is a square wave, and the control circuit is configured to generate the square wave to have a same total number of peaks as the total number of peaks in the desired acceleration, or to have a peak-to-peak magnitude that is based on the maximum peak-to-peak magnitude of the desired acceleration, or to have a frequency content that is substantially the same as the frequency content of the desired acceleration.

Embodiment 19 includes the haptic-enabled device of any one of embodiments 12 to 18, wherein the haptic actuator is a linear resonant actuator (LRA). In aspects, a method of generating a haptic effect by a haptic effect system is provided. The method comprises receiving a parameter value of a haptic parameter that describes desired movement for a haptic effect to be generated by a haptic actuator of the haptic effect system, generating a waveform based on the parameter value, generating a first portion of a haptic drive signal based on the waveform, measuring movement of the actuator based on the first portion of the haptic drive signal, and generating a second portion of the haptic drive signal based on the measured movement of the actuator and based on the desired movement. In aspects, the first portion of the haptic drive signal provides acceleration, and the second portion of the haptic drive signal provides braking. In aspects, the haptic parameter includes a number of peaks in a desired acceleration, a frequency content of the desired acceleration, or a maximum peak-to-peak magnitude of the desired acceleration. In aspects, the actuator is embedded in a rigid mass, or the actuator is attached to the touchpad or touchscreen of the haptic effect system, the touchpad or touchscreen being is suspended on a mounting surface via a suspension.

Embodiment 20 includes a haptic-enabled device, comprising: a haptic actuator; a movement sensor; a control circuit configured to: determine a drive signal for the haptic actuator based on desired movement for a haptic effect and based on a model that describes transient behavior of the haptic actuator, wherein the desired movement is defined by information stored on the haptic-enabled device; apply the drive signal to the haptic actuator; measure, via the movement sensor, movement output by the haptic actuator based on the drive signal being applied to the haptic actuator to determine a measured movement of the haptic actuator; determine a movement error that indicates a difference between the measured movement output by the haptic actuator and the desired movement; adjust the drive signal based on the movement error to generate an adjusted drive signal; and apply the adjusted drive signal to the haptic actuator to generate the haptic effect.

Embodiment 21 includes the haptic-enabled device of embodiment 20, wherein the haptic-enabled device is a phone having a rigid component in which the haptic actuator is embedded.

Embodiment 22 includes the haptic-enabled device of embodiment 20 or 21, wherein the haptic-enabled device includes a touchpad or touchscreen that is suspended on a mounting surface via a suspension, wherein the haptic actuator is attached to the touchpad or touchscreen, and wherein the model accounts for the attachment of the haptic actuator to the touchpad or touchscreen.

Embodiment 23 includes the haptic-enabled device of any one of embodiments 20 to 22, wherein the desired movement is desired acceleration for the haptic effect, and wherein the information that defines the desired movement is a time-dependent acceleration waveform.

Embodiment 24 includes the haptic-enabled device of embodiment 23, wherein the movement sensor is an acceleration sensor, wherein the movement that is measured is an acceleration being output by the haptic actuator, and wherein the movement error is an acceleration error that indicates a difference between the desired acceleration and the acceleration being output by the haptic actuator.

Embodiment 25 includes the haptic-enabled device of embodiment 24, wherein the model describes a relationship between drive signals and resulting accelerations that the haptic actuator is predicted to generate in response to the drive signals.

Embodiment 26 includes the haptic-enabled device of embodiment 25, wherein the model defines an inverse transfer function that relates the drive signal as an output of the inverse transfer function based to the desired acceleration as an input to the inverse transfer function.

Embodiment 27 includes the haptic-enabled device of embodiment 25 or 26, wherein the control circuit is configured to adjust the drive signal based on the acceleration error.

Embodiment 28 includes the haptic-enabled device of any one of embodiments 20 to 27, wherein the control circuit is configured to detect that a virtual button of the haptic-enabled device is being clicked, and to control the haptic actuator to generate the haptic effect in response to detecting the virtual button of the haptic-enabled device being clicked.

Embodiment 29 includes a non-transitory computer-readable medium having instructions stored thereon that, when executed by a control circuit of a haptic-enabled device, causes the control circuit to: determine a drive signal for a haptic actuator of the haptic-enabled device based on a desired movement for a haptic effect and based on a model that describes transient behavior of the haptic actuator, wherein the desired movement is defined by information stored on the haptic-enabled device; apply the drive signal to the haptic actuator; measure, via a movement sensor of the haptic-enabled device, movement output by the haptic actuator based on the driving signal applied to the haptic actuator, so as to determine a measured movement of the haptic actuator; determine a movement error that indicates a difference between the measured movement output by the haptic actuator and the desired movement; adjust the drive signal based on the movement error to generate an adjusted drive signal; and apply the adjusted drive signal to the haptic actuator to generate the haptic effect.

Embodiment 30 includes a haptic-enabled device, comprising: a haptic actuator; a movement sensor; and a control circuit configured to: receive a parameter value of a haptic parameter that describes desired movement for a haptic effect to be generated by the haptic actuator; generate a driving portion of a drive signal based on the parameter value; apply the driving portion of the drive signal to the haptic actuator; measure, via the movement sensor, movement output by the haptic actuator to determine a measured movement of the haptic actuator; generate, after the driving portion is generated, a braking portion of the drive signal based on the measured movement, by using closed-loop control to cause the measured movement to change toward a defined characteristic.

Embodiment 31 includes the haptic-enabled device of embodiment 30, wherein the haptic parameter is an acceleration parameter, and the desired movement described by the haptic parameter is desired acceleration for the haptic effect.

Embodiment 32 includes the haptic-enabled device of embodiment 31, wherein the movement sensor is an acceleration sensor, and the measured movement is a measured acceleration of the haptic actuator, and wherein the control circuit is configured to generate the braking portion by using closed-loop control to cause the measured acceleration to change toward zero.

Embodiment 33 includes the haptic-enabled device of embodiment 31 or 32, wherein the haptic parameter defines at least one of: (i) a total number of peaks in the desired acceleration, (ii) a maximum peak-to-peak magnitude of the desired acceleration, or (iii) a frequency content for the desired acceleration.

Embodiment 34 includes the haptic-enabled device of embodiment 33, wherein the driving portion is a square wave, and the control circuit is configured to generate the square wave to have a same total number of peaks as the total number of peaks in the desired acceleration, or to have a peak-to-peak magnitude that is based on the maximum peak-to-peak magnitude of the desired acceleration, or to have a frequency content that is substantially the same as the frequency content of the desired acceleration.

Embodiment 35 includes the haptic-enabled device of embodiment 34, wherein the haptic actuator is a linear resonant actuator (LRA).

Embodiment 36 includes a method of generating a haptic effect by a haptic effect system, comprising: receiving a parameter value of a haptic parameter that describes desired movement for a haptic effect to be generated by a haptic actuator of the haptic effect system; generating a waveform based on the parameter value; generating a first portion of a haptic drive signal based on the waveform; measuring movement of the actuator based on the first portion of the haptic drive signal; and generating a second portion of the haptic drive signal based on the measured movement of the actuator and based on the desired movement.

Embodiments 37 includes the method of embodiment 36, wherein the first portion of the haptic drive signal provides acceleration and the second portion of the haptic drive signal provides braking.

Embodiments 38 includes the method of embodiment 36 or 37, wherein the haptic parameter includes a number of peaks in a desired acceleration, a frequency content of the desired acceleration, or a maximum peak-to-peak magnitude of the desired acceleration.

Embodiments 39 includes the method of any one of embodiments 36 to 38, wherein the actuator is embedded in a rigid mass, or the actuator is attached to the touchpad or touchscreen of the haptic effect system, the touchpad or touchscreen being is suspended on a mounting surface via a suspension.

While various embodiments have been described above, it should be understood that they have been presented only as illustrations and examples of the present invention, and not by way of limitation. It will be apparent to persons skilled in the relevant art that various changes in form and detail can be made therein without departing from the spirit and scope of the invention. Thus, the breadth and scope of the present invention should not be limited by any of the above-described exemplary embodiments, but should be defined only in accordance with the appended claims and their equivalents. It will also be understood that each feature of each embodiment discussed herein, and of each reference cited herein, can be used in combination with the features of any other embodiment. All patents and publications discussed herein are incorporated by reference herein in their entirety.

**Claims**

1. A method performed by a haptic-enabled device, the method comprising:

   determining a drive signal for a haptic actuator of the haptic-enabled device based on desired movement for a haptic effect and based on a model that describes transient behavior of the haptic actuator, wherein the desired movement is defined by information stored on the haptic-enabled device;
   applying the drive signal to the haptic actuator;
   measuring, via a movement sensor of the haptic-enabled device, movement output by the haptic actuator based on the drive signal being applied to the haptic actuator to determine a measured movement of the haptic actuator;
   determining a movement error that indicates a difference between the measured movement output by the haptic actuator and the desired movement;
   adjusting the drive signal based on the movement error to generate an adjusted drive signal; and
   applying the adjusted drive signal to the haptic actuator to generate the haptic effect.

2. The method of claim 1, wherein the haptic-enabled device is a phone having a rigid component in which the haptic actuator is embedded.

3. The method of claim 1 or 2, wherein the haptic-enabled device includes a touchpad or touchscreen that is suspended on a mounting surface via a suspension, wherein the haptic actuator is attached to the touchpad or touchscreen, and wherein the model accounts for the attachment of the haptic actuator to the touchpad or touchscreen.

4. The method of any one of claims 1-3, wherein the desired movement is desired acceleration for the haptic effect, and wherein the information that defines the desired movement is a time-dependent acceleration waveform.

5. The method of claim 4, wherein the movement sensor is an acceleration sensor, wherein the movement that is measured is an acceleration being output by the haptic actuator, and wherein the movement error is an acceleration error that indicates a difference between the desired acceleration and the acceleration being output by the haptic actuator.

6. The method of claim 5, wherein the model describes a relationship between drive signals and resulting accelerations that the haptic actuator is predicted to generate in response to the drive signals.

7. The method of claim 6, wherein the model defines an inverse transfer function that relates the drive signal as an output of the inverse transfer function based to the desired acceleration as an input to the inverse transfer function.

8. The method of any one of claims 5-7, further comprising adjusting the drive signal based on the acceleration error.

9. The method of any one of claims 5-8, further comprising adjusting the drive signal based on a time-dependent derivative of the acceleration error.

10. The method of any one of claims 5-9, further comprising adjusting the drive signal based on a time-dependent integral of the acceleration error.

11. The method of any one of claims 1-10, further comprising detecting that a virtual button of the haptic-enabled device is being clicked, and controlling the haptic actuator to generate the haptic effect in response to detecting the virtual button of the haptic-enabled device being clicked.

12. A haptic-enabled device, comprising a haptic actuator, a movement sensor, and a control circuit configured to perform the method of any one of claims 1-11.

13. A non-transitory computer-readable medium having instructions stored thereon that, when executed by a control circuit of a haptic-enabled device, causes the control circuit to perform the method of any one of claims 1-11.

14. A method of generating a haptic effect by a haptic effect system, comprising:

> receiving a parameter value of a haptic parameter that describes desired movement for a haptic effect to be generated by a haptic actuator of the haptic effect system;
> generating a waveform based on the parameter value;
> generating a first portion of a haptic drive signal based on the waveform;
> measuring movement of the actuator based on the first portion of the haptic drive signal; and
> generating a second portion of the haptic drive signal based on the measured movement of the actuator and based on the desired movement.

15. A haptic-enabled device comprising a haptic actuator and a control circuit configured to perform the method of claim 14.

Haptic-Enabled Device 100

Control Circuit 110

Haptic actuator 120

Movement Sensor 130

Non-transitory computer-readable medium 140

FIG. 1

Non-transitory computer-readable medium <u>140</u>

Haptic Actuator Model <u>141</u>

Reference Acceleration Profile <u>143</u>

Acceleration waveform

Actuator Control Module <u>149</u>

Other Module <u>142</u>

FIG. 2A

Non-transitory computer-readable medium <u>140</u>

Haptic Actuator Model <u>141</u>

Parameter Values <u>144</u>

Haptic Effect 1:
3 Peaks
1 $g_{pp}$
150 Hz

Haptic Effect 2:
2 Peaks
1.5 $g_{pp}$

Actuator Control Module <u>149</u>

Other Module <u>142</u>

FIG. 2B

250  252  200

254

220  FIG. 3A

260

220A

FIG. 3B

EP 3 650 993 A1

FIG. 4A

FIG. 4B

EP 3 650 993 A1

FIG. 4C

FIG. 4D

EP 3 650 993 A1

FIG. 4E

EP 3 650 993 A1

Ref.
Acc. → Inverse Model → Volt. → [Limit] → LRA (Plant)

## FIG. 5A

Inverse Model → Volt.

Ref.
Acc. → (+/−) → error → Controller (PID or Inverse Model) → (+/+) → [Limit] → Drive Signal → LRA (Plant) → Measured Acc. by Accelerometer

## FIG. 5B

```
┌─────────────────────────────────────────────────────┐
│ Determining a drive signal for a haptic actuator based on │          500
│ desired movement for a haptic effect and based on a model │
│   that describes transient behavior of the haptic actuator │
└─────────────────────────────────────────────────────┘
                            │                                            502
                            ▼
┌─────────────────────────────────────────────────────┐
│        Applying the drive signal to the haptic actuator        │
└─────────────────────────────────────────────────────┘          503
                            │
                            ▼
┌─────────────────────────────────────────────────────┐
│   Measuring, via a movement sensor of the haptic-enabled   │
│        device, movement output by the haptic actuator        │          504
└─────────────────────────────────────────────────────┘
                            │
                            ▼
┌─────────────────────────────────────────────────────┐
│  Determining an movement error that indicates a difference  │
│  between the measured movement and the desired movement  │          506
└─────────────────────────────────────────────────────┘
                            │
                            ▼
┌─────────────────────────────────────────────────────┐
│   Adjusting the drive signal based on the movement error, so   │
│            as to generate an adjusted drive signal            │          508
└─────────────────────────────────────────────────────┘
                            │
                            ▼
┌─────────────────────────────────────────────────────┐
│  Controlling the haptic actuator to generate a haptic effect by  │
│    applying the adjusted drive signal to the haptic actuator    │          510
└─────────────────────────────────────────────────────┘
```

FIG. 5C

FIG. 6B

FIG. 6A

FIG. 7B

FIG. 7A

Measured acceleration

Reference/Desired
Acceleration

FIG. 8A

FIG. 8B

FIG. 8C

FIG. 8D

FIG. 8E

FIG. 9A

Value of input parameter(s) → Square Wave Generator — 912

Switch

Brake Controller — 914

Limit

LRA (Plant)

EP 3 650 993 A1

EP 3 650 993 A1

```
+-------------------------------------------------------+        900
| Receiving a parameter value of a haptic parameter that |
| describes desired movement for a haptic effect to be   |
| generated by a haptic actuator of a haptic-enabled device |
+-------------------------------------------------------+        902
                          |
                          v
+-------------------------------------------------------+
| Generating a driving portion (e.g., square wave) of a drive |
| signal based on the parameter value                   |
+-------------------------------------------------------+        904
                          |
                          v
+-------------------------------------------------------+
| Applying the driving portion of the drive signal to the haptic |
| actuator                                              |
+-------------------------------------------------------+        906
                          |
                          v
+-------------------------------------------------------+
| Measuring, via a movement sensor of the haptic-enabled |
| device, movement output by the haptic actuator so as to |
| determine measured movement                           |
+-------------------------------------------------------+        908
                          |
                          v
+-------------------------------------------------------+
| Generating, after the driving portion is generated, a braking |
| portion of the drive signal based on the measured movement, |
| by using closed-loop control to cause the measured    |
| movement to converge toward a defined characteristic  |
+-------------------------------------------------------+        910
```

FIG. 9B

Switch to brake controller

FIG. 9C

Brake controller activated    End of square wave

$T_{switch}$

FIG. 10

FIG. 11

Europäisches
Patentamt

European
Patent Office

Office européen
des brevets

## EUROPEAN SEARCH REPORT

Application Number

EP 19 20 8144

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 206 105 A1 (GOERTEK INC [CN]) 16 August 2017 (2017-08-16) * paragraphs [0016] - [0046] * ----- | 1-15 | INV. G06F3/01 G06F3/041 H01H3/00 |
| X | US 9 520 036 B1 (BUUCK DAVID CHARLES [US] ET AL) 13 December 2016 (2016-12-13) * column 3, line 7 - column 6, line 39 * * column 7, line 45 - column 8, line 62 * ----- | 1-15 | |
| X | US 2011/075835 A1 (HILL MATTHEW [US]) 31 March 2011 (2011-03-31) * paragraphs [0027] - [0049] * ----- | 1-15 | |

| | TECHNICAL FIELDS SEARCHED (IPC) |
|---|---|
| | G06F H01H G08B |

The present search report has been drawn up for all claims

| Place of search | Date of completion of the search | Examiner |
|---|---|---|
| Munich | 23 March 2020 | Gkeli, Maria |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 20 8144

This annex lists the patent family members relating to the patent documents cited in  the above-mentioned European search report.
The members are as contained in the European Patent Office EDP file on
The European Patent Office is in no way liable for these particulars which are merely given for the purpose of information.

23-03-2020

| Patent document cited in search report | | Publication date | Patent family member(s) | | Publication date |
|---|---|---|---|---|---|
| EP 3206105 | A1 | 16-08-2017 | CN | 105511514 A | 20-04-2016 |
| | | | DK | 3206105 T3 | 15-04-2019 |
| | | | EP | 3206105 A1 | 16-08-2017 |
| | | | US | 2018183372 A1 | 28-06-2018 |
| | | | WO | 2017113651 A1 | 06-07-2017 |
| US 9520036 | B1 | 13-12-2016 | NONE | | |
| US 2011075835 | A1 | 31-03-2011 | AU | 2010300576 A1 | 12-04-2012 |
| | | | AU | 2014203309 A1 | 10-07-2014 |
| | | | BR | 112012007307 A2 | 19-04-2016 |
| | | | CN | 102714683 A | 03-10-2012 |
| | | | CN | 104917885 A | 16-09-2015 |
| | | | CN | 108616660 A | 02-10-2018 |
| | | | EP | 2484104 A1 | 08-08-2012 |
| | | | EP | 3082328 A1 | 19-10-2016 |
| | | | GB | 2474338 A | 13-04-2011 |
| | | | JP | 5995116 B2 | 21-09-2016 |
| | | | JP | 2013507059 A | 28-02-2013 |
| | | | JP | 2015119488 A | 25-06-2015 |
| | | | KR | 20120058627 A | 07-06-2012 |
| | | | KR | 20130114264 A | 16-10-2013 |
| | | | KR | 20160042469 A | 19-04-2016 |
| | | | US | 2011075835 A1 | 31-03-2011 |
| | | | US | 2013300549 A1 | 14-11-2013 |
| | | | US | 2015061848 A1 | 05-03-2015 |
| | | | US | 2016071384 A1 | 10-03-2016 |
| | | | US | 2017236388 A1 | 17-08-2017 |
| | | | US | 2018174409 A1 | 21-06-2018 |
| | | | US | 2020027320 A1 | 23-01-2020 |
| | | | WO | 2011041535 A1 | 07-04-2011 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62622648

- US 250494